# EUROPEAN PATENT APPLICATION

(11) **EP 2 230 544 A1**
(43) Date of publication of application: **22.09.2010**
(21) Application number: 08870042.2
(22) Date of filing: 19.12.2008
(51) Int. Cl.: G02B 6/42, G02B 6/122, H01L 31/02, H01S 5/022

(54) **OPTICAL TRANSMISSION MODULE PROVIDED WITH REINFORCING COMPONENT FOR REINFORCING SUBSTRATE OF OPTICAL TRANSMISSION MODULE, AND ELECTRONIC DEVICE PROVIDED WITH THE OPTICAL TRANSMISSION MODULE**

(30) Priority: 07.01.2008 JP 2008000390
(71) Applicant: Omron Corporation, Kyoto-shi, Kyoto 600-8530 (JP)
(72) Inventor: NAKAGAWA, Yuseke, Kyoto-shi Kyoto 600-8530 (JP); SAMESHIMA, Hiroshi, Kyoto-shi Kyoto 600-8530 (JP); KOIKE, Takayoshi, Kyoto-shi Kyoto 600-8530 (JP); YASUDA, Naru, Kyoto-shi Kyoto 600-8530 (JP)
(74) Representative: Giovannini, Francesca
(86) International application number: PCT/JP2008/073155
(87) International publication number: WO 2009/087882

(57) **Abstract**

A light transmission module (1) according to the present invention includes a reinforcement component (3) for reinforcing a substrate (2); wherein the reinforcement component is arranged on a surface mounted with the optical element (6) of the substrate, and the reinforcement component includes at least two structural portions longer than a maximum length portion of the optical element when seen from a direction perpendicular to the substrate surface, the two structural portions being arranged facing each other with a region, where at least the optical element is arranged, in between when seen from the direction perpendicular to the substrate surface. Therefore, a light transmission module of high quality can be easily manufactured while maintaining the rigidity of the substrate.

## Description

### TECHNICAL FIELD

The present invention relates to a light transmission module including a reinforcement component for reinforcing a substrate of the light transmission module, and an electronic device equipped with the light transmission module.

### BACKGROUND ART

In recent years, an optical communication network enabling large capacity data communication at high speed is expanding. The optical communication network is expected to be implemented from inter-devices to in-device in the future. A light guide that can be arrayed is being desired to realize the print wiring substrate as an optical wiring.

The light guide has a double structure of a center core, which is called a core, and a sheath, which is called a clad, where the index of refraction of the core is higher than the clad. In other words, the optical signal that entered the core is propagated by repeating total reflection inside the core.

In recent years, in particular, realization of a flexible optical wiring mounted on a smaller and thinner commercially-off-the-shelf device with the light guide is desired. A light guide having high bending property is being developed by using a material more flexible than the prior art for the material of the core and the clad of the light guide. The data transmission between the substrates in the device can be carried out with the light guide by using such light guide having high bending property.

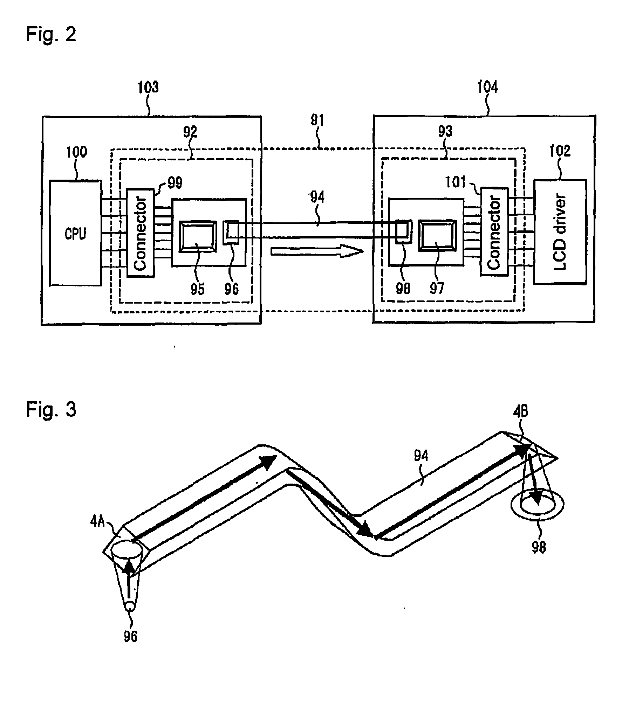

A mechanism of light transmission in the light transmission module using the light guide will be described with reference to Fig. 2, Fig. 3, and Figs. 4(a) and 4(b).

Fig. 2 is a view showing a schematic configuration of a light transmission module 91. As shown in Fig. 2, the light transmission module 91 includes a light transmission processing unit 92, a light reception processing unit 93, and a light guide 94 serving as a light transmission path.

The light transmission processing unit 92 is configured to include a light emission drive portion 95 and a light emitting portion 96. The light emission drive portion 95 drives the light emission of the light emitting portion 96 based on an electric signal input from outside (master side substrate, e.g., CPU 100) through a connector (connecting component) 99. The light emission drive portion 95 is configured by an IC (Integrated Circuit) for light emission drive. The connector 99 is an electrical connecting portion for connecting the electrical wiring for transmitting the electric signal from the outside, and the light emission drive portion 95.

The light emitting portion 96 emits light based on the drive control by the light emission drive portion 95. The light emitting portion 96 is configured by a light emitting element such as a VCSEL (Vertical Cavity-Surface Emitting Laser). The light emitted from the light emitting portion 96 is applied to the light incident side end of the light guide 94 as an optical signal.

The light reception processing unit 93 is configured to include an amplifier 97 and a light receiving portion 98. The light receiving portion 98 receives the light serving as the optical signal exit from the light exit side end of the light guide 94, photoelectric-converts the same, and outputs an electric signal. The light receiving portion 98 is configured by a light receiving element such as a PD (Photo-Diode).

The amplifier 97 amplifies the electric signal output from the light receiving portion 98, and outputs to the outside. For instance, the output electric signal is transmitted to the slave side substrate (e.g., LCD driver 102) through a connector 101. The amplifier 97 is configured by an IC for amplification. The connector 101 is an electrical connecting portion for connecting the amplifier 97, and an electrical wiring for transmitting the electric signal to the outside.

The light guide 94 is a medium for transmitting the light exit from the light emitting portion 96 to the light receiving portion 98.

Fig. 3 is a view schematically showing a state of light transmission in the light guide 94. As shown in Fig. 3, the light guide 94 is configured by a column-shaped member having flexibility. A light incident surface 4A is arranged at the light incident side end of the light guide 94, and a light exit surface 4B is arranged at the light exit side end.

The light exit from the light emitting portion 96 enters the light incident side end of the light guide 94 from a direction perpendicular to the light transmitting direction of the light guide 94. The incident light is reflected at the light incident surface 4A, and advances through the light guide 94. The light that advanced through the light guide 94 and reached the light exit side end is reflected at the light exit surface 4B, and exit in a direction perpendicular to the light transmitting direction of the light guide 94. The exit light is applied to the light receiving portion 98, and subjected to photoelectric conversion in the light receiving portion 98.

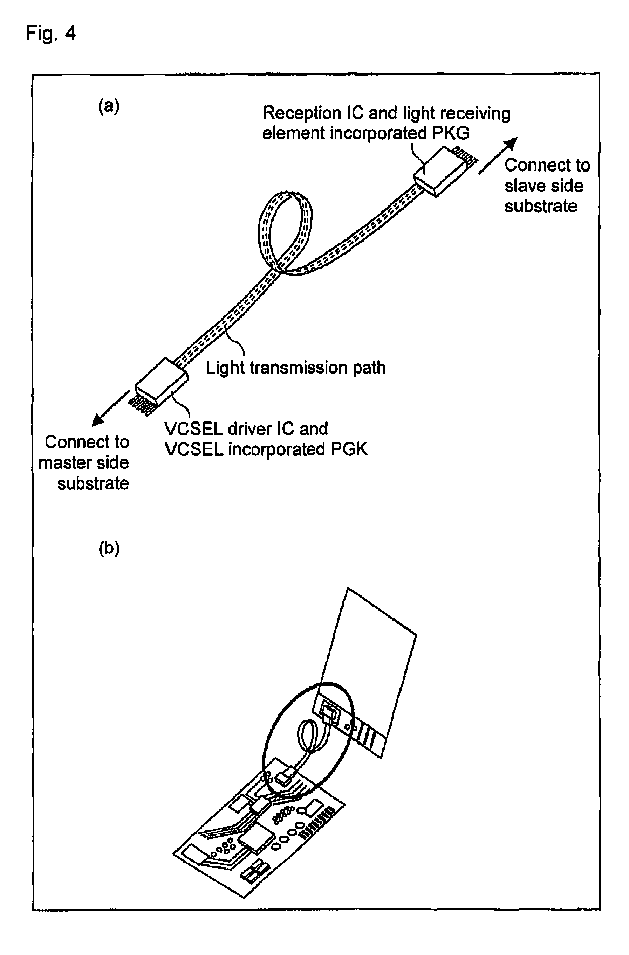

Fig. 4(a) is a perspective view showing an outer appearance of a light transmission module. Fig. 4(b) is a perspective view showing an inner appearance of a foldable mobile phone incorporating the light transmission module.

As shown in Fig. 4(b), the light transmission module 91 is mounted on a small device such as a mobile phone. With the use of such light transmission module, large capacity data transmission can be carried out at high speed from a main control substrate mounted in the mobile phone to an application circuit substrate. Thus, the light transmission module excels as a data transmission module.

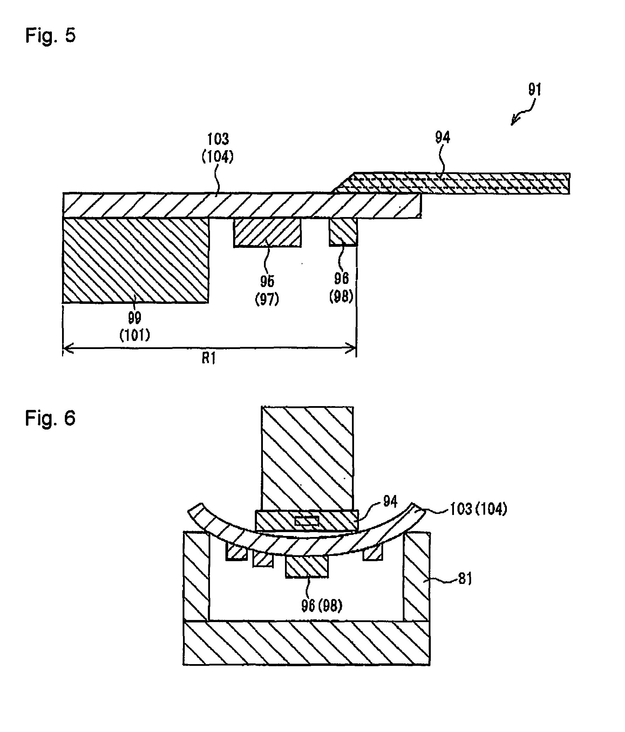

The conventional light transmission module has a configuration in which all members including the light emitting and receiving element and the light guide are mounted on one substrate surface (e.g., patent document 1). Alternatively, a configuration in which various types of members are arranged on both surfaces of the substrate so as to sandwich the substrate, as shown in Fig. 5, may be adopted.

Fig. 5 is a cross-sectional view of the light transmission module in a case where the light transmission processing unit (or light reception processing unit) in the conventional light transmission module is cut in a direction horizontal to the light transmitting direction of the light guide.

The light transmission module 91 shown in Fig. 5 has a configuration in which the light guide 94 is arranged on one surface of the substrate 103 (104), and various types of members such as the connector 99 (101), the light emission drive portion 95, and the light emitting portion 96 are arranged on the other surface of the substrate 103. In the following, the surface of the substrate arranged with the light guide is referred to as the back surface of the substrate, and the opposite surface arranged with various types of members other than the light guide such as the connector and the optical element is referred to as the front surface.

As described above, thinning, miniaturization, and smaller space are strongly desired in the light transmission module since it is often used in a small device such as a mobile phone.

More specifically, the light transmission path package (PKG) incorporating the light emitting and receiving element, various circuit elements, and various types of members such as the connecting portion of the light guide is desirably miniaturized by devising the size of each member and the arrangement of the member. Furthermore, in order to miniaturize the light transmission module, devisal is also necessary in the arrangement with a connector (connecting component) for connecting the substrate (e.g., CPU, LCD driver etc.) of the electronic device and the light transmission path package.

Furthermore, the light transmission module is thinned by further thinning the substrate itself for mounting the light transmission path package.
Patent document 1: Japanese Unexamined Publication "Japanese Unexamined Patent Publication No. 2001-507814 (date of publication: July 9, 1998).

### DISCLOSURE OF THE INVENTION

In the configuration shown in Fig. 5, the following problems arise when manufacturing the light transmission module.

If a thin substrate is used to thin the light transmission module, the rigidity of the substrate mounting various types of members such as the light guide and the optical element is lost and the substrate easily bends, and hence the light transmission module of high quality becomes difficult to manufacture.

Fig. 6 is a view showing the cross-section of a work when mounting the light guide 94 on the back surface of the substrate 103 (104) in the manufacturing step of the light transmission module 91 shown in Fig. 5.

As shown in Fig. 6, when arranging the light guide 94 on the back surface of the substrate 103, the work is installed such that a jig 81 supports both ends of the substrate 103 with the front surface of the substrate 103 mounted with various types of members facing down.

Since the substrate 103 is thin and does not have rigidity, the central part bends if only both ends are supported by the jig 81. If the substrate bends in such manner, the positional relationship between the light emitting portion 96 (light receiving portion 98), which is already mounted, and the light guide 94, which is positioned before mounting, shifts, and the sealing agent or the adhesive may strip. Thus, maintaining the quality of the light transmission module is very difficult in the manufacturing of the light transmission module.

In view of the above-described conventional problems, it is an object of the present invention to provide a light transmission module including a reinforcement component for reinforcing a substrate of the light transmission module capable of preventing the substrate from bending in the manufacturing step and maintaining the light transmission module at high quality by maintaining the rigidity of the substrate, and an electronic device equipped with the light transmission module.

To solve the problems described above, a light transmission module of the present invention relates to a light transmission module including an optical element for emitting or receiving an optical signal with respect to at least one end, which includes an incident/exit port of the optical signal, of a light transmission path including a core made of material having transparency, and a substrate for mounting the optical element, the end of the light transmission path being arranged to optically couple with the optical element; the light transmission module including a reinforcement component for reinforcing the substrate; wherein the reinforcement component is arranged on a surface mounted with the optical element of the substrate, and the reinforcement component includes at least two structural portions longer than a maximum length portion of the optical element when seen from a direction perpendicular to the substrate surface, the two structural portions being arranged facing each other with a region, where at least the optical element is arranged, in between when seen from the direction perpendicular to the substrate surface.

According to the above configuration, the optical element is arranged on the substrate of the light transmission module, and the reinforcement component is further arranged on the same surface as the mounting surface of the optical element.

The reinforcement component includes at least two structural portions, and the respective structural portions of the reinforcement component are arranged facing each other with a region, where at least the optical element is arranged, in between when seen from the direction perpendicular to the substrate surface. The maximum length of each structural portion of the reinforcement component arranged to sandwich the optical element when seen from the direction perpendicular to the substrate surface is longer than the maximum length of the optical element.

The rigidity of the substrate at the periphery of the optical element is particularly maintained since the reinforcement component including at least the structural portion having sufficient length is arranged on the substrate so as to sandwich the optical element. Specifically, the substrate can be maintained flat in the longitudinal direction of each structural portion of the reinforcement component, and the substrate can be prevented from bending in the relevant direction.

Thus, the bend in at least one direction of the substrate, particularly the substrate at the periphery of the optical element, can be prevented. Since the substrate does not bend in at least one direction, the positional relationship between the optical element, which is mounted, and the light guide, which is positioned before mounting, does not shift. Furthermore, the risk of stripping of the sealing agent and the adhesive due to the bending of the substrate can be reduced. Thus, a stable quality of the light transmission module can be maintained in the manufacturing step of the light transmission module.

The light transmission module of the present invention can maintain the rigidity of the substrate and prevent the substrate from bending in the longitudinal direction thereof with the reinforcement component, and hence the mounting of the light guide to the back surface of the substrate can be facilitated (accurately arranged at the defined position). The stripping of the resin agent can be prevented. The light transmission module of high quality thus can be manufactured. The effect is particularly large with respect to the light transmission module using a thin substrate that easily bends.

For the configuration of the light transmission path described above, a configuration including a core made of material having transparency and a clad made of material having an index of refraction different from the index of refraction of the core may be considered. The clad may be made of solid material, liquid material, or gas material.

To solve the problems described above, a light transmission module of the present invention relates to a light transmission module including an optical element for emitting or receiving an optical signal with respect to at least one end, which includes an incident/exit port of the optical signal, of a light transmission path including a core made of material having transparency, and a substrate for mounting the optical element, the end of the light transmission path being arranged to optically couple with the optical element; the light transmission module including a reinforcement component for reinforcing the substrate, the reinforcement component including, on at least one part, a connecting component for electrically connecting a substrate of an external electronic device and the light transmission module; wherein the connecting component is arranged on a surface mounted with the optical element of the substrate; and the connecting component includes at least two structural portions longer than a maximum length portion of the optical element when seen from a direction perpendicular to the substrate surface, the two structural portions being arranged facing each other with a region, where at least the optical element is arranged, in between when seen from the direction perpendicular to the substrate surface.

The light transmission module described above requires a connecting component for connecting the substrate of the electronic device and the light transmission module to transmit the converted electric signal to the external electronic device.

Therefore, an extra member does not need to be arranged or stacked by using the connecting components essential in the light transmission module for the reinforcement component, whereby the light transmission module can be formed smaller while maintaining the rigidity of the substrate.

To solve the problems described above, a light transmission module of the present invention relates to a light transmission module including an optical element for emitting or receiving an optical signal with respect to at least one end, which includes an incident/exit port of the optical signal, of a light transmission path including a core made of material having transparency, and a substrate for mounting the optical element, the end of the light transmission path being arranged to optically couple with the optical element; the light transmission module including a reinforcement component for reinforcing the substrate, the reinforcement component including, on at least one part, a connecting component for electrically connecting a substrate of an external electronic device and the light transmission module; wherein the connecting component is arranged on a surface mounted with the optical element of the substrate; and the connecting component includes a structural portion that covers a surface opposite to an adhering surface with the substrate in the light transmission path, the structural portion including a recess on the substrate side, and the light transmission path being accommodated in a space formed by the substrate and the recess.

According to such configuration, the light transmission path is accommodated in a cavity formed by the substrate and the connecting component in place of the optical element. In other words, a configuration of stacking the light transmission path and the connecting component is adopted. Thus, a region for mounting the optical element and other electronic components can be greatly ensured on the surface opposite to the surface mounted with the light transmission path and the connecting component while reinforcing the substrate.

Furthermore, a small amount of sealing agent is traced only at the vicinity of the end of the connecting component to enable sealing while leaving a cavity at the bottom surface of the connecting component. Therefore, the dust is prevented from attaching to the mirror end face of the light transmission path.

An electronic device including the above-described light transmission module is also encompassed within the scope of the invention.

As described above, the light transmission module of the present invention includes a reinforcement component for reinforcing the substrate; wherein the reinforcement component is arranged on a surface mounted with the optical element of the substrate, and the reinforcement component includes at least two structural portions longer than a maximum length portion of the optical element when seen from a direction perpendicular to the substrate surface, the two structural portions being arranged facing each other with a region, where at least the optical element is arranged, in between when seen from the direction perpendicular to the substrate surface.

Thus, the rigidity of the substrate can be maintained, and a light transmission module of high quality can be easily manufactured.

### BRIEF DESCRIPTION OF THE DRAWINGS

Fig. 1(a) is a plan view showing a configuration of a light transmission module 1 according to an embodiment of the present invention, Fig. 1(b) is a cross-sectional view taken along line A-A' of the light transmission module shown in Fig. 1(a), and Fig. 1(c) is a cross-sectional view taken along line B-B' of the light transmission module shown in Fig. 1(a).
Fig. 2 is a view showing a schematic configuration of a light transmission module 91.
Fig. 3 is a view schematically showing a state of light transmission in a light guide 94.
Fig. 4(a) is a perspective view showing an outer appearance of a light transmission module, and Fig. 4(b) is a perspective view showing an inner appearance of a foldable mobile phone incorporating the light transmission module.
Fig. 5 is a cross-sectional view of the light transmission module in a case where the light transmission processing unit (or light reception processing unit) in the conventional light transmission module is cut in a direction horizontal to the light transmitting direction of the light guide.
Fig. 6 is a view showing the cross-section of a work when mounting the light guide 94 on the back surface of the substrate 103 (104) in the manufacturing step of the light transmission module 91 shown in Fig. 5.
Figs. 7(a) and 7(b) are views showing the cross-section of a work when mounting the light guide 4 in the manufacturing step of the light transmission module 1 according to the present embodiment.
Figs. 8(a) and 8(b) are plan views showing a configuration of the light transmission module 1 according to another embodiment of the present invention.
Figs. 9(a) and 9(b) are plan views showing a configuration of the light transmission module 1 according to another embodiment of the present invention.
Fig. 10(a) is a plan view showing a configuration of the light transmission module 1 according to another embodiment of the present invention, (b) is a cross-sectional view taken along line B-B' of the light transmission module shown in (a).
Fig. 11(a) is a plan view showing a configuration of the light transmission module 1 according to another embodiment of the present invention, Fig. 11(b) is a side view of the light transmission module 1 shown in Fig. 11(a) when seen from the Y-axis direction, and Fig. 11(c) is a side view of the light transmission module 1 shown in Fig. 11(a) when seen from the X-axis direction.
Fig. 12(a) is a plan view showing a configuration of the light transmission module 1 according to another embodiment of the present invention, Fig. 12(b) is a side view of the light transmission module 1 shown in Fig. 12(a) when seen from the Y-axis direction, and Fig. 12(c) is a side view of the light transmission module 1 shown in Fig. 12(a) when seen from the X-axis direction.
Fig. 13 is a cross-sectional view of the light transmission module when the light transmission processing unit (or light reception processing unit) in another light transmission module of the prior art is cut in a direction horizontal to the light transmitting direction of the light guide.
Fig. 14(a) is a plan view showing a configuration of the light transmission module according to the embodiment of the present invention, Fig. 14(b) is a plan view showing the configuration of the light transmission module shown in Fig. 14(a) when the connector is removed, Fig. 14(c) is a cross-sectional view taken along line A-A' of the light transmission module 1 shown in Fig. 14(a), and Fig. 14(d) is a cross-sectional view taken along line A-A' of the light transmission module 1 when the connector 3 of the light transmission module 1 shown in Fig. 14(a) is fitted to a receptor 10.
Fig. 15(a) is a plan view showing a configuration of the light transmission module 1 according to another embodiment of the present invention, Fig. 15(b) is a cross-sectional view taken along line A-A' of the light transmission module 1 shown in Fig. 15(a), and Fig. 15(c) is a cross-sectional view taken along line A-A' of another light transmission module 1 shown in Fig. 15(a).
Fig. 16(a) is a plan view showing a configuration of the light transmission module 1 according to another embodiment of the present invention, and Fig. 16(b) is a cross-sectional view taken along line A-A' of the light transmission module 1 shown in Fig. 16(a).
Fig. 17 is a plan view showing a configuration of the light transmission module 1 according to another embodiment of the present invention.
Fig. 18(a) is a plan view showing a configuration of the light transmission module 1 according to another embodiment of the present invention, Fig. 18(b) is a cross-sectional view taken along line A-A' of the light transmission module 1 shown in Fig. 18(a), and Fig. 18(c) is a cross-sectional view taken along line B-B' of the light transmission module shown in Fig. 18(a).
Fig. 19(a) is a plan view showing a configuration of the light transmission module 1 according to another embodiment of the present invention, and Fig. 19(b) is a cross-sectional view taken along line B-B' of the light transmission module 1 shown in Fig. 19(a).
Fig. 20(a) is a plan view showing a configuration of the light transmission module 1 according to another embodiment of the present invention, and Fig. 20(b) is a cross-sectional view taken along line A-A' of the light transmission module 1 shown in Fig. 20(a).
Fig. 21(a) is a plan view showing a configuration of the light transmission module 1 according to another embodiment of the present invention, and Fig. 21(b) is a cross-sectional view taken along line A-A' of the light transmission module 1 shown in Fig. 21(a).
Fig. 22(a) is a perspective view showing an outer appearance of the foldable mobile phone including the light transmission path according to the present embodiment, Fig. 22(b) is a block diagram of a portion where the light transmission path is applied in the foldable mobile phone shown in Fig. 22(a), and Fig. 22(c) is a perspective plan view of the hinge portion in the foldable mobile phone shown in Fig. 22(a).
Fig. 23(a) is a perspective view showing an outer appearance of a printing device including the light transmission path according to the present embodiment, Fig. 23(b) is a block diagram showing the main parts of the printing device shown in Fig. 23(a), and Fig. 23(c) and 23(d) are perspective views showing a curved state of the light transmission path when the printer head is moved (driven) in the printing device.
Fig. 24 is a perspective view showing an outer appearance of a hard disc recording and reproducing device including the light transmission path according to the present embodiment.
Fig. 25(a) is a plan view showing a configuration of the light transmission module according to the embodiment of the present invention, Fig. 25(b) is a plan view showing a configuration of the light transmission module shown in Fig. 25(a) when the connector is removed, and Fig. 25(c) is a cross-sectional view taken along line B-B' of the light transmission module 1 shown in Fig. 25(a).
Fig. 26(a) is a plan view showing a configuration of the light transmission module according to the embodiment of the present invention, and Fig. 26(b) is a cross-sectional view taken along line B-B' of the light transmission module 1 shown in Fig. 26(a).
Fig. 27(a) is a plan view showing a configuration of the light transmission module according to the embodiment of the present invention, and Fig. 27(b) is a cross-sectional view taken along line B-B' of the light transmission module 1 shown in Fig. 27(a).
Fig. 28(a) is a plan view showing a configuration of the light transmission module according to the embodiment of the present invention, and Fig. 28(b) is a cross-sectional view taken along line B-B' of the light transmission module 1 shown in Fig. 28(a).

### DESCRIPTION OF SYMBOLS

- 1: light transmission module
- 2: substrate
- 3: connector (reinforcement component/connecting component)
- 3a: leg portion
- 4: light guide (light transmission path)
- 4A: light incident surface
- 4B: light exit surface
- 5: reinforcement unit (reinforcement component)
- 5a: leg portion
- 5b: plate portion
- 6: optical element
- 7: resin agent
- 7a: sealing agent (resin agent)
- 7b: underfill agent (resin agent)
- 9: circuit element
- 10: receptor
- 15: opening
- 31: hole
- 32: recess
- 33: recess
- 34: opening
- 40: foldable mobile phone (electronic device)
- 40a: body
- 41: control unit
- 42: external memory
- 43: camera
- 44: display unit
- 50: printing device (electronic device)
- 51: printer head
- 52: paper
- 60: hard disc recording and reproducing device (electronic device)
- 61: disc
- 62: head
- 63: substrate introducing portion
- 64: drive portion
- 81: jig
- 91: light transmission module
- 92: light transmission processing unit
- 93: light reception processing unit
- 94: light guide
- 95: light emission drive portion
- 96: light emitting portion
- 97: amplifier
- 98: light receiving portion
- 99: connector
- 100: CPU
- 101: connector
- 102: LCD driver
- 103: substrate
- 104: substrate

### BEST MODE FOR CARRYING OUT THE INVENTION

One embodiment of the present invention will be described below based on the drawings.

### [First embodiment]

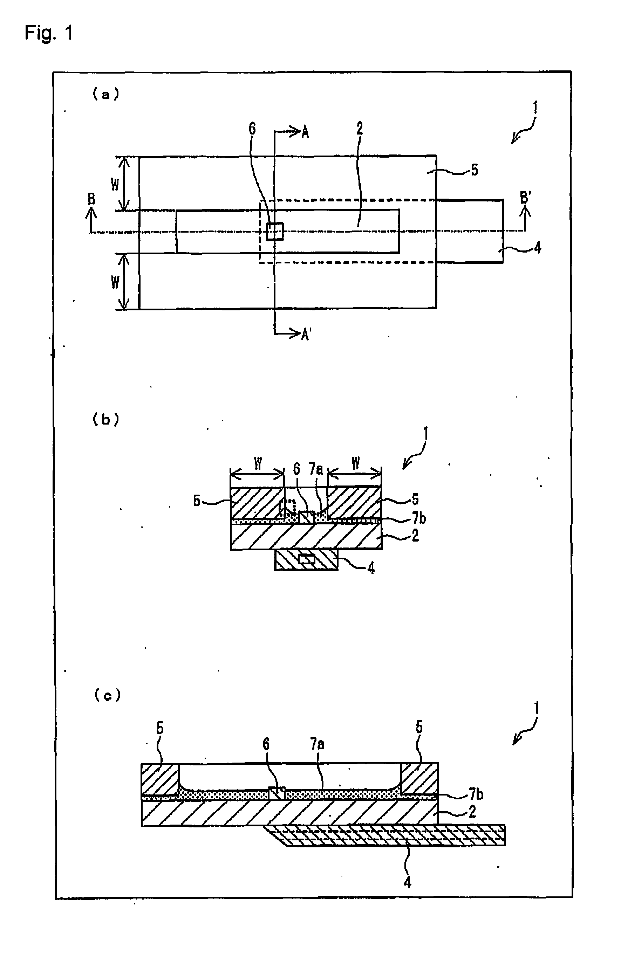

Fig. 1(a) is a plan view showing a configuration of a light transmission module 1 according to an embodiment of the present invention, Fig. 1(b) is a cross-sectional view taken along line A-A' of the light transmission module 1 shown in Fig. 1(a), and Fig. 1(c) is a cross-sectional view taken along line B-B' of the light transmission module 1 shown in Fig. 1(a).

Only one end of the light transmission module is illustrated in Figs. 1(a) to 1(c), and the functions serving as the light transmission processing unit or the light reception processing unit are provided, but both ends, that is, both the light transmission processing unit and the light reception processing unit may have the configurations shown in Figs. 1(a) to 1(c) in the light transmission module of the present invention.

As shown in Figs. 1(a) to 1(c), the light transmission module 1 of the present embodiment has a configuration in which an optical element 6 is mounted on the front surface of a substrate 2, and a reinforcement unit 5 is arranged so as to surround the periphery of the optical element 6 in a direction parallel to the substrate surface. The optical element 6 is implemented as a VCSEL if the light transmission module 1 has the function of the light transmission processing unit, and as a PD if the light transmission module 1 has the function of the light reception processing unit.

According to the above configuration, the arrangement region of the optical element 6 on the substrate 2 and the region at the periphery thereof are surrounded by the reinforcement unit 5 in a direction parallel to the substrate surface to reinforce the same, so that the substrate 2 is prevented from bending in various directions including the direction parallel to and the direction perpendicular to the light transmitting direction.

A light guide 4 is mounted on the surface opposite to the front surface where the optical element 6 and the reinforcement unit 5 are arranged, that is, the back surface.

As shown in Fig. 1(c), the end face of the light guide is diagonally cut in a range of between θ30° and 50° with respect to the surface contacting the substrate of the light guide 4. The core center of the diagonally cut portion and the center of the light emitting surface (light receiving surface for the light reception processing unit) of the optical element 6 are arranged in a positional relationship enabling optical coupling by way of a hole (not shown) formed in the substrate. The size of the hole is φ80 um for the light transmission processing unit and φ260 um for the light reception processing unit, but is not limited thereto.

The width W of the side wall of the reinforcement unit 5 arranged along the side in the longitudinal direction of the substrate 2 (thickness W in the direction perpendicular to the light transmitting direction in the light guide 4) is not particularly limited, but preferably has a sufficient thickness such that at least one part of an adhering region in the front surface of the reinforcement unit 5 and the substrate 2 overlaps the arrangement region of the light guide 4 arranged on the back surface of the substrate 2.

According to the above configuration, the region to mount the light guide 4 in the back surface of the substrate 2 has at least one part reinforced by the reinforcement unit 5 at the opposite surface (front surface of the substrate 2). Thus, the bending of the substrate 2 that occurs in the step of mounting the light guide 4 can be prevented, and the light guide 4 can be more accurately mounted.

As shown in Figs. 1(b) or 1(c), the height of the reinforcement unit 5 from the front surface of the substrate 2 preferably has a height of greater than or equal to the height of the optical element 6 from the front surface.

Thus, the reinforcement unit 5 has a sufficient thickness (height from the front surface of the substrate 2) in the direction perpendicular to the substrate surface. The rigidity can be sufficiently maintained even if the reinforcement unit 5 is made from the same material as the substrate 2.

Therefore, the reinforcement unit 5 can be made from the same material as the substrate 2, and can be integrally molded with the substrate 2. If the reinforcement unit 5 is integrally molded with the substrate 2, the light transmission module 1 can be manufactured at low cost and while maintaining the positional accuracy of the reinforcement unit 5 itself high.

Alternatively, the reinforcement unit 5 may be formed with a single body and then arranged on the substrate 2. The reinforcement unit 5 may be made from the same material as the substrate 2, or may be made from resin material such as polyimide, LCP, epoxy, glass epoxy, and PEEK, rubber, and the like.

Various types of mounted circuit elements (chip resistor, chip capacitor, IC, or connector) may be used for the reinforcement unit 5. Thus, the arrangement region of the substrate 2 can be effectively utilized and the light transmission module 1 can be miniaturized by using the circuit element originally necessary for the light transmission module 1 for the reinforcement unit 5.

The reinforcement unit 5 may be formed from metal. The metal has sufficient rigidity compared to the materials described above, and thus the thickness of greater than or equal to the optical element 6 does not need to be maintained. Therefore, the light transmission module 1 can be thinned.

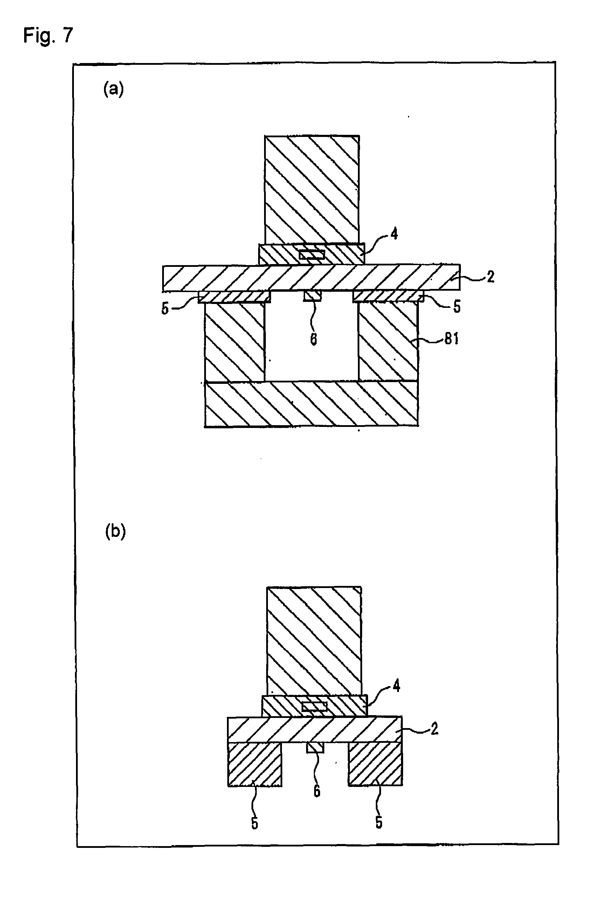

Fig. 7(a) and Fig. 7(b) are views showing the cross-section of a work when mounting the light guide 4 in the manufacturing step of the light transmission module 1 according to the present embodiment.

As described above, the light transmission module 1 of the present invention includes the reinforcement unit 5. Thus, as shown in Fig. 7(a), the reinforcement unit 5 supports the substrate 2 from below, so that the substrate 2 does not deform by the pressure applied at the time of mounting the light guide 4 even if the substrate 2 is thin and does not have rigidity, and the positional relationship of the optical element 6, which is already mounted, and the light guide 4, which is positioned before mounting, does not shift.

Furthermore, if the height of the reinforcement unit 5 from the front surface of the substrate 2 is greater than or equal to the height of the optical element 6 from the front surface, the light guide 4 can be mounted on the back surface of the substrate 2 without using the jig 81, as shown in Fig. 7(b), since the reinforcement unit 5 acts as the jig 81. A margin for supporting with the jig 81 thus does not need to be ensured at the front surface of the substrate 2. Therefore, the margin portion, which is conventionally a dead space, can be used to arrange the circuit element, or the margin portion can be eliminated to further miniaturize the light transmission module 1.

Moreover, in the present embodiment, a sealing agent 7a is filled to a recess formed by the substrate 2 and the reinforcement unit 5, as shown in Fig. 1(b) and Fig. 1(c). The sealing agent 7a is filled for the purpose of protecting the optical element from moisture and dust, and preventing degradation of the optical element. An underfill agent 7b is injected between each member (reinforcement unit 5, optical element 6) and the substrate 2 for the purpose of adhering each member to mount to the substrate 2.

Since the substrate that does not have rigidity easily bends in the prior art, the risk the sealing agent 7a and the underfill agent 7b strip due to the bending of the substrate is high. Thus, a stable quality of the light transmission module cannot be maintained in the manufacturing steps of the light transmission module.

However, the rigidity of the substrate 2 can be maintained since the light transmission module 1 of the present invention includes the reinforcement unit 5, whereby the substrate 2 is maintained flat while suppressing bend, and the risk of stripping of the sealing agent 7a and the underfill agent 7b can be reduced. (Hereinafter, the sealing agent 7a and the underfill agent 7b are collectively referred to as resin agent 7 if distinction is not necessary).
Since the light transmission module 1 of the present invention includes the reinforcement unit 5, a space in the frame-shaped reinforcement unit 5 is filled with the sealing agent 7a, and the rigidity of the substrate 2 is further enhanced. Therefore, the bending of the substrate 2 can be further suppressed. The reinforcement unit 5 can also prevent the sealing agent 7a from leaking out from the substrate 2.

Another reason the configuration of the reinforcement unit 5 can reduce the risk of stripping of the resin agent 7 is as follows.

Generally, the resin agent 7 is desired to fix the member while closely attaching to each member to contact, and to have hydrophilic property with respect to each member to ensure stability and reliability. Since the resin agent 7 has hydrophilic property, the sealing surface (within broken line frame of Fig. 1(b)) near the contacting portion of the resin agent 7 and each member (e.g., optical element 6, side wall of reinforcement unit 5 etc.) curves. Such curved shape is hereinafter referred to as fillet shape.

The adhering area of the resin agent 7 filled inside the frame of the reinforcement unit 5 and the side wall of the reinforcement unit 5 becomes large due to the fillet shape, and the resin agent 7 and the reinforcement unit 5 closely attach to each other with a stronger force by the large adhering area. The force of closely attaching to each other acts in a direction opposite to the force of separating the resin agent 7 and the reinforcement unit 5 when the substrate 2 bends as in Fig. 6, and the risk of stripping of the resin agent 7 further reduces.

The light transmission module with stable quality thus can be manufactured.

Furthermore, another member may be stacked on the reinforcement unit 5 while protecting the optical element 6 by having the thickness of the reinforcement unit 5 in the direction perpendicular to the surface of the substrate 2 to greater than or equal to the thickness of the optical element 6. In other words, the reinforcement unit 5 can be used as a supporting member of another member.

A plurality of members thus can be stacked and mounted, and the region for arranging members in the substrate 2 can be saved, whereby smaller space and miniaturization of the light transmission module can be realized. The configuration of stacking another member on the optical element 6 will be described in detail afterwards.

### (Variant 1-1)

The above description relates to the configuration of the light transmission module 1 including the reinforcement unit 5 having a frame shape so as to surround the periphery of the optical element 6 mounted on the substrate 2, but the light transmission module 1 of the present invention is not limited to such configuration.

Various changes can be made on the shape of the reinforcement unit 5 in the range the rigidity with respect to the substrate 2 is maintained. For instance, the reinforcement unit 5 does not necessarily need to surround four sides of the optical element 6, and the reinforcement unit 5 may be molded to a horseshoe shape to surround three sides of the optical element 6. Alternatively, a plurality of reinforcement units 5 may be arranged at the periphery of the optical element 6. In other words, the reinforcement unit 5 includes at least two structural portions longer than the maximum length portion of the optical element when seen from a direction perpendicular to the substrate surface, and such two structural portions are arranged facing each other with a region, where at least the optical element is arranged, in between when seen from a direction perpendicular to the substrate surface.

According to such configuration, the reinforcement unit 5 is arranged such that at least two portions of the reinforcement unit 5 sandwich the optical element 6 in a direction horizontal to the substrate 2 surface. The two portions of the reinforcement unit 5 have the maximum length longer than the maximum length of the optical element 6.

The rigidity of the substrate 2 is maintained in the longitudinal direction of each portion of the reinforcement unit 5 since the reinforcement unit 5 having sufficient length is arranged to sandwich the optical element 6. Thus, the bending of the substrate 2 in the longitudinal direction of each portion of the reinforcement unit 5 can be prevented.

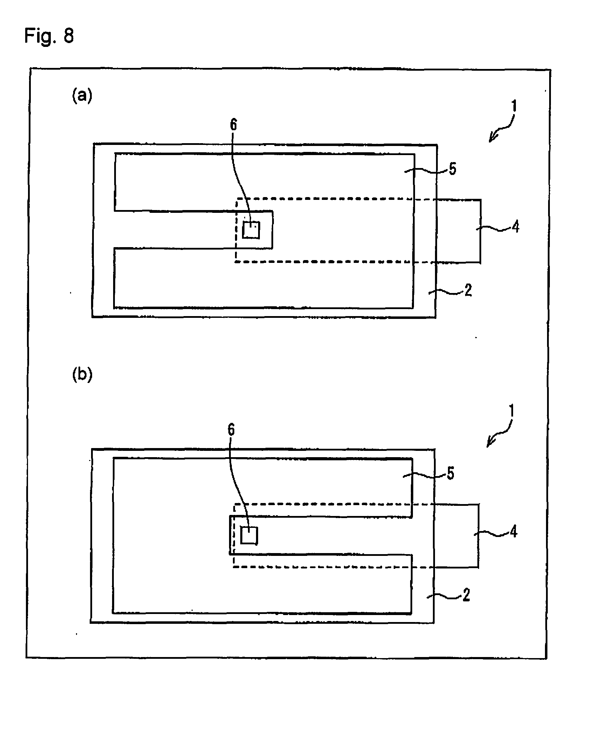

Fig. 8(a) and Fig. 8(b) are plan views showing a configuration of the light transmission module 1 according to another embodiment of the present invention.

The light transmission module 1 shown in Fig. 8(a) and Fig. 8(b) differs from that shown in Fig. 1(a) in that one side of the frame shape of the reinforcement unit 5 arranged to surround the optical element 6 is removed to have a horseshoe shape. The reinforcement unit 5 of the light transmission module 1 shown in Fig. 8(b) has a configuration in which one side on the side for connecting the light guide 4 at the back surface of the substrate 2 is removed, and the reinforcement unit 5 of the light transmission module 1 shown in Fig. 8(a) has a configuration in which the side opposing the side on the side for connecting the light guide 4 is removed.

According to the above configuration, the reinforcement unit 5 can support the substrate 2 from below in the manufacturing step of mounting the light guide 4 on the back surface of the substrate 2 since the reinforcement unit 5 is mounted on the substrate 2 so as to surround three sides of the optical element 6. Therefore, the rigidity of the substrate can be maintained even if the substrate is thin, and the substrate can be prevented from deforming by the pressure applied when mounting the light guide. The positional relationship between the optical element, which is already mounted, and the light guide, which is positioned before mounting, thus does not shift, and a light transmission module can be manufactured at stable quality.

It should be noted that even if one side of the reinforcement unit 5 is removed, the gap that forms as a result is very small, and thus the amount of sealing agent 7a that leaks out from the substrate can be suppressed to a small amount even if the sealing agent 7a is filled inside the reinforcement unit 5.

The rigidity of the substrate 2 further enhances, the strength of the substrate with respect to bend increases, and the stripping of the sealing agent and the element adhesive (underfill agent) due to the bending of the substrate can be prevented by curing the sealing agent 7a.

The filled sealing agent 7a forms a fillet shape in the vicinity of the side wall of the reinforcement unit 5, and thus the risk of stripping can be further reduced.

The available region of the substrate 2 obtained when one side of the frame shape of the reinforcement unit 5 shown in Fig. 1(a) is removed can be used for other purposes. Specifically, the relevant region can be effectively used as a space for arranging other electronic elements. The space for arranging the electronic elements thus does not need to be expanded in excess, and a more miniaturized light transmission module 1 can be realized compared to the frame-shaped reinforcement unit 5.

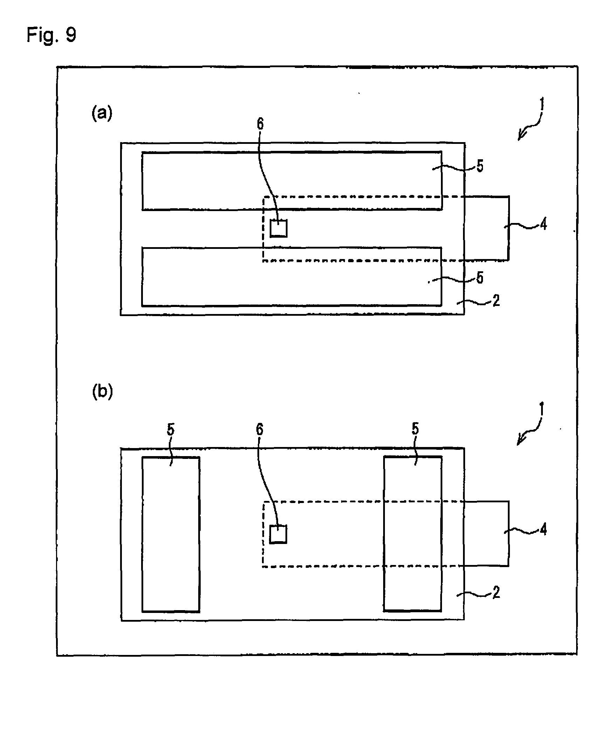

Fig. 9(a) and Fig. 9(b) are plan views showing a configuration of the light transmission module 1 according to another embodiment of the present invention.

The light transmission module shown in Fig. 9(a) and Fig. 9(b) differs from that shown in Fig. 1(a) in that two opposing sides of the frame shape of the reinforcement unit 5 arranged to surround the optical element 6 are removed. In other words, two reinforcement units 5 are arranged facing each other by way of the optical element 6 on the front surface of the substrate 2.

According to the above configuration, the element mounting area on the front surface of the substrate 2 can be further expanded compared to the configuration of the light transmission module described above, and thus the available space can be effectively used while maintaining the rigidity of the substrate 2, and a more miniaturized light transmission module 1 can be realized.

### (Variant 1-2)

The above description relates to the configuration of the light transmission module 1 including the reinforcement unit 5 formed so as to surround the optical element 6, but the light transmission module 1 of the present invention is not limited to such configuration.

In addition to the optical element 6, other circuit elements such as the IC, the resistor, and the capacitor may be accommodated in the enclosure shape of the reinforcement unit 5.

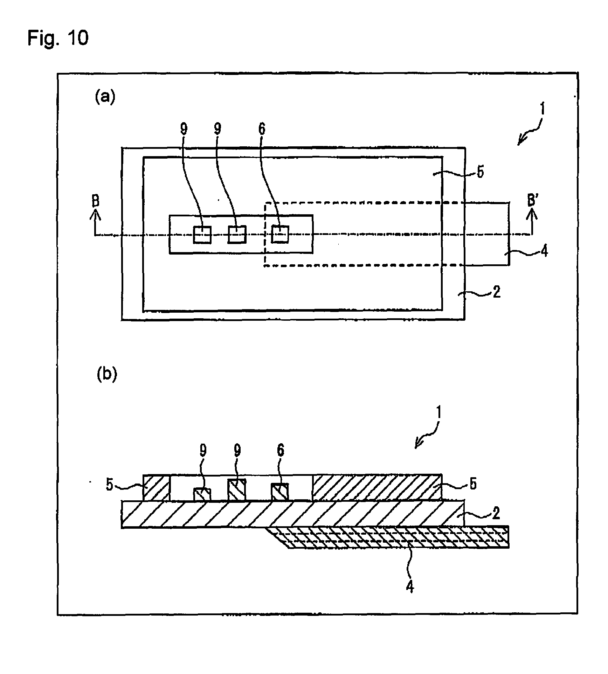

Fig. 10(a) is a plan view showing a configuration of the light transmission module 1 according to another embodiment of the present invention. Fig. 10(b) is a cross-sectional view taken along line B-B' of the light transmission module shown in Fig. 10(a).

As shown in Figs. 10(a) and 10(b), other necessary circuit elements 9 are accommodated within the frame-shape of the reinforcement unit 5, in addition to the optical element 6.

Although not shown, if the height of the reinforcement unit 5 from the front surface of the substrate 2 is greater than or equal to the height of the optical element 6 and each circuit element 9, the connector 3 may be mounted on the reinforcement unit 5.

According to such configuration, the necessary optical element 6 and the circuit element 9 can be accommodated in a space formed by the reinforcement unit 5 and the connector 3, so that the space can be effectively used. Therefore, the space for mounting the element can be saved while maintaining the rigidity of the substrate 2 by the reinforcement unit 5, and miniaturization of the light transmission module can be realized.

### (Variant 1-3)

A configuration of reducing the adhering area of the reinforcement unit 5 and the substrate 2 while maintaining the reinforcement strength of the reinforcement unit 5 with respect to the substrate 2 will now be described.

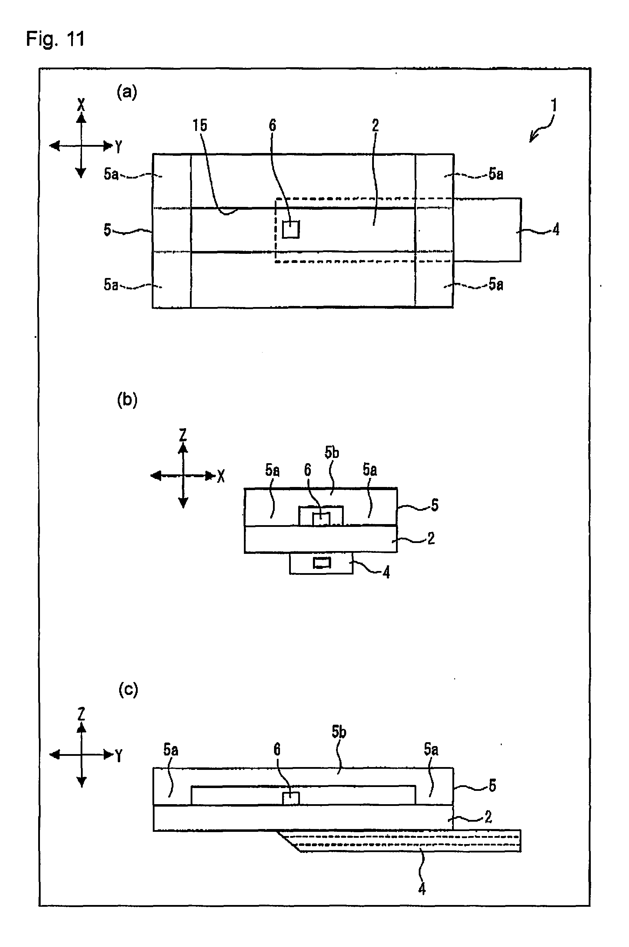

Fig. 11(a) is a plan view showing a configuration of the light transmission module 1 according to another embodiment of the present invention, Fig. 11(b) is a side view of the light transmission module 1 shown in Fig. 11(a) when seen from the direction horizontal to the light transmitting direction in the light guide 4, and Fig. 11(c) is a side view of the light transmission module 1 shown in Fig. 11(a) when seen from the direction perpendicular to the light transmitting direction in the light guide 4.

In the following, the direction parallel to the substrate surface orthogonal to the light transmitting direction in the light guide 4 is the X-axis direction, the direction parallel to the substrate surface orthogonal to the X-axis (horizontal direction with respect to the light transmitting direction) is the Y-axis direction, and the normal direction of the substrate surface is the Z-axis direction.

As shown in Figs. 11(a) to 11(c), the reinforcement unit 5 in the present variant includes a plate portion 5b having a flat plate shape that covers the upper surface of the optical element 6 (surface opposing the surface to be adhered to the substrate 2), and a columnar leg portion 5a for supporting the end of the plate portion 5b.

More specifically, the rectangular plate portion 5b has a hollow shape including a rectangular opening 15, where the four corners of the plate portion 5b are supported by a quadratic prism shaped leg portion 5a. However, the shape of the reinforcement unit 5 (leg portion 5a, plate portion 5b) is not limited to the above.

The reinforcement unit 5 of the light transmission module 1 shown in Figs. 11(a) to 11(c) differs from that of Figs. 1(a) to 1(c) in that each side wall of the frame-shaped reinforcement unit 5 has a bored shape so as to have a gate shape. The thickness of the reinforcement unit 5, that is, the height from the front surface of the substrate 2 may be the same as that of Figs. 1(a) to 1(c). The distance H (height H of cavity) between the plate portion 5b supported by the leg portion 5a and the substrate 2 is preferably a small height of smaller than or equal to a several hundred µm.

The effect substantially similar to the frame-shaped reinforcement unit 5 in that the sealing agent 7a can be prevented from leaking out to the outside of the reinforcement unit 5 by surface tension even if the sealing agent 7a is injected through the opening 15 is obtained.

According to such configuration, the portion to adhere with the substrate 2 is only the columnar leg portion 5a in the reinforcement unit 5. Therefore, the adhering area with the substrate 2 can be reduced compared to the configuration of Figs. 1(a) to 1(c).

Reducing the adhering area of the substrate 2 means reducing the area to apply the underfill agent 7b, and thus the usage amount of the underfill agent 7b can be reduced. Thus, the amount the extra underfill agent 7b runs out towards the central part of the substrate 2 can be considerably reduced when the reinforcement unit 5 is pushed against the substrate 2. The central part of the substrate 2 is ensured as a region for mounting the optical element 6 and the circuit element 9, and thus the influence on the alignment of the elements to be arranged at the central part can be reduced by reducing the amount the underfill agent 7b runs out. Therefore, the stable light transmission module 1 of high quality can be manufactured.

In the above description, the plate portion 5b of the reinforcement unit 5 has a configuration of including the opening 15, but is not limited thereto. The plate portion 5b may not include the opening 15, and may completely cover the upper surface of the optical element 6. In this case, the distance H (height H of cavity) between the plate portion 5b supported by the leg portion 5a and the substrate 2 is greater than or equal to the height of the optical element 6 from the substrate 2.

If the plate portion 5b does not include the opening 15, the sealing agent 7a can be injected from a gap formed by the leg portion 5a and the leg portion 5a.

According to such configuration, the plate portion 5b without the opening 15 closely attaches to the substrate 2 through the sealing agent 7a, and hence the rigidity of the substrate 2 can be further enhanced.

In the above description, the leg portion 5a supports the plate portion 5b at four corners, but this is not the sole case. The leg portion 5a may be further arranged on the reinforcement unit 5, as necessary, according to the area and the rigidity of the plate portion 5b or the required strength.

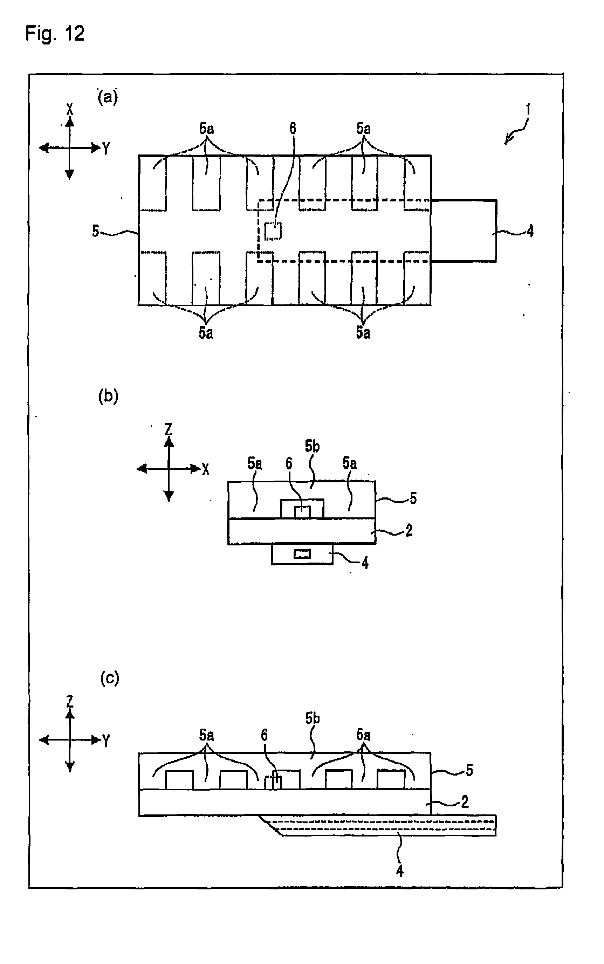

Fig. 12(a) is a plan view showing a configuration of the light transmission module 1 according to another embodiment of the present invention, Fig. 12(b) is a side view of the light transmission module 1 shown in Fig. 12(a) when seen from the Y-axis direction, and Fig. 11(c) is a side view of the light transmission module 1 shown in Fig. 11(a) when seen from the X-axis direction.

As shown in Figs. 12(a) to 12(c), the reinforcement unit 5 includes the plate portion 5b of substantially the same shape as the substrate 2, and includes a plurality of leg portions 5a at a constant interval along two sides in the longitudinal direction of the plate portion 5b. Such plurality of leg portions 5a are adhered to the substrate 2 through the underfill agent 7b, and support the plate portion 5b.

According to the above configuration, the leakage of the sealing agent 7a is less likely to occur compared to the above-described examples, the adhering strength and the reinforcement degree with the substrate 2 increase by the amount of increase of the adhering area between the reinforcement unit 5 and the substrate 2, and the rigidity of the substrate 2 can be maintained.

The leg portion 5a and the plate portion 5b according to the present variant are made of resin material such as polyimide, LCP, and epoxy, or metal material.

Furthermore, other members may be mounted on the plate portion 5b. Alternatively, other circuit elements and connectors may be used for the plate portion 5b.

### (Variant 1-4)

In the above variants, the reinforcement unit 5 in which the leg portion 5a and the plate portion 5b of the reinforcement unit 5 are integrally molded with the same material has been described, but the reinforcement unit 5 to be mounted on the light transmission module 1 of the present invention is not limited thereto. The leg portion 5a and the plate portion 5b may be molded with different materials.

The shape of the leg portion 5a is not limited to a quadratic prism shape. The leg portion 5a may have any shape as long as the leg portion 5a has a necessary height (distance from the surface of the substrate 2 to the plate portion 5b) for accommodating the optical element 6 in the space formed between the substrate 2 and the plate portion 5b.

For instance, the four leg portions 5a supporting the four corners of at least the plate portion 5b of the plurality of leg portions 5a shown in Figs. 12(a) to 12(c) may be formed with the solder. Other leg portions 5a may also be formed with the solder. In this case, the plate portion 5b is fabricated with resin material such as polyimide, LCP, and epoxy, or metal material.

According to the above configuration, the reinforcement unit 5 can be arranged on the substrate 2 through the reflow step by forming the leg portion 5a with the solder, and the manufacturing steps of the light transmission module 1 can be simplified while maintaining the rigidity of the substrate 2.

Furthermore, since the solder functions as a wall, the sealing agent 7a is prevented from leaking outside by the surface tension even if the sealing agent 7a is injected from between the leg portions 5a made of solder.

In the above-described embodiment, the light transmission module having a configuration in which the light guide is arranged on the back surface of the substrate, and the substrate is sandwiched with the optical element and the light guide has been described by way of example, but the light transmission module 1 of the present invention is not limited to such configuration. The reinforcement unit 5 of the present invention is also applicable to the light transmission module in which the light guide is embedded in the substrate.

According to the above configuration, although the man hour produces to form a space for embedding the light guide in the substrate, the bulk for the light guide can be reduced as a whole, and hence the light transmission module can be thinned.

Whether to embed or not to embed the light guide in the substrate can be appropriately and freely designed according to situations including to what extent the light transmission module is to be thinned, whether the manufacturing cost and the man hour are limited, and the like.

As described above, the light transmission module 1 of the present invention includes the reinforcement unit 5 arranged so as to surround or cover the optical element 6 mounted on the substrate 2, and thus the rigidity of the substrate 2 can be maintained. Furthermore, the cured resin agent 7 enhances the reinforcement strength by injecting the resin agent 7 to a space formed by the reinforcement unit 5 (and other members). Consequently, the bending of the substrate in the manufacturing step of the light transmission module can be prevented, and the quality of the light transmission module can be maintained. The sealing agent 7a sealed inside is prevented from leaking outside by the enclosure structure of the reinforcement unit 5.

In the first embodiment, the configuration of the light transmission module in which the reinforcement unit 5 is arranged to face at least two side surfaces of the optical element 6, and the reinforcement unit 5 is mounted on the substrate 2 so as to surround the optical element 6 has been described. In variants 1-3 and 1-4, the configuration in which the reinforcement unit 5 includes the leg portion 5a to reduce the adhering surface of the reinforcement unit 5 and the substrate 2 as much as possible has been described.

A configuration of the light transmission module 1 in which all or one part of the reinforcement unit 5 of the above-described embodiment is realized with a connector (connecting component) will be described in a second embodiment.

### [Second embodiment]

### (Background art and problem)

The thinning, the miniaturization, and the smaller space of the light transmission module are strongly desired, as mentioned above. The miniaturization of the light transmission module is often realized through devisal in the arrangement of each member such as the connector and the optical element.

However, the configuration shown in Fig. 5 has the following problems. Various members other than the light guide 94 (e.g., connector 99, light emission drive portion 95, and light emitting portion 96) are arranged on the surface opposite to the surface arranged with the light guide 94 in the substrate 103. Therefore, a region for arranging the remaining members needs to be ensured on the substrate over a wide range (range R1), and further miniaturization of the light transmission module becomes difficult to achieve.

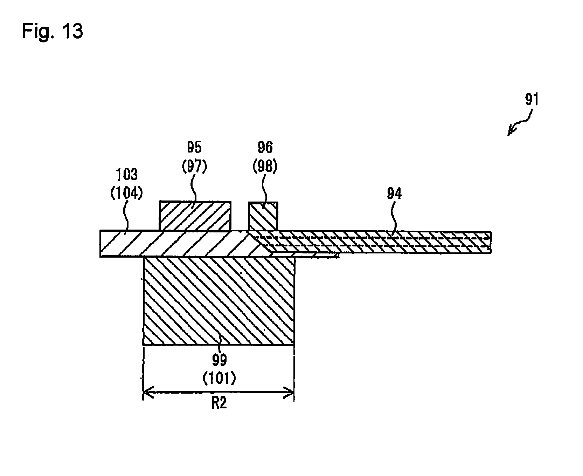

A configuration of the light transmission module shown in Fig. 13 is considered, for example, to achieve further miniaturization in the light transmission module shown in Fig. 5. In the example shown in Fig. 13, the connector is arranged on one surface of the substrate, and the light emitting portion and other circuit elements are arranged on the side opposite to the substrate surface arranged with the connector so as to sandwich the substrate with the connector.

According to the above configuration, a region required for arranging various types of members can be saved (range R2) compared to the configuration shown in Fig. 5, and further miniaturization of the light transmission module can be realized.

Furthermore, the configuration shown in Fig. 13 has the following problem. To manufacture the light transmission module shown in Fig. 13, a space for embedding the light guide needs to be ensured in the substrate. Therefore, the light transmission module of Fig. 13 sacrifices degree of freedom in design due to the limitation in the arrangement of the light guide. The manufacturing of the light transmission module of Fig. 13 also has problems in that the steps are complicated, the man hour increases, and the manufacturing cost is high.

The miniaturization of the light transmission is desirably realized while maintaining the degree of freedom in the arrangement of the light guide.

In the second embodiment described below, the light transmission module in which the degree of freedom in design in the light transmission module is enhanced using the reinforcement unit 5 for maintaining the rigidity of the substrate described in the first embodiment and the miniaturization of the light transmission module is realized without complicating the manufacturing steps and increasing the manufacturing cost, the electronic device, and the connecting component (connector) for connecting the substrate of the electronic device and the light transmission module will be described.

In the present embodiment, all or one part of the reinforcement unit 5 is realized by the connector.

### (Configuration of light transmission module)

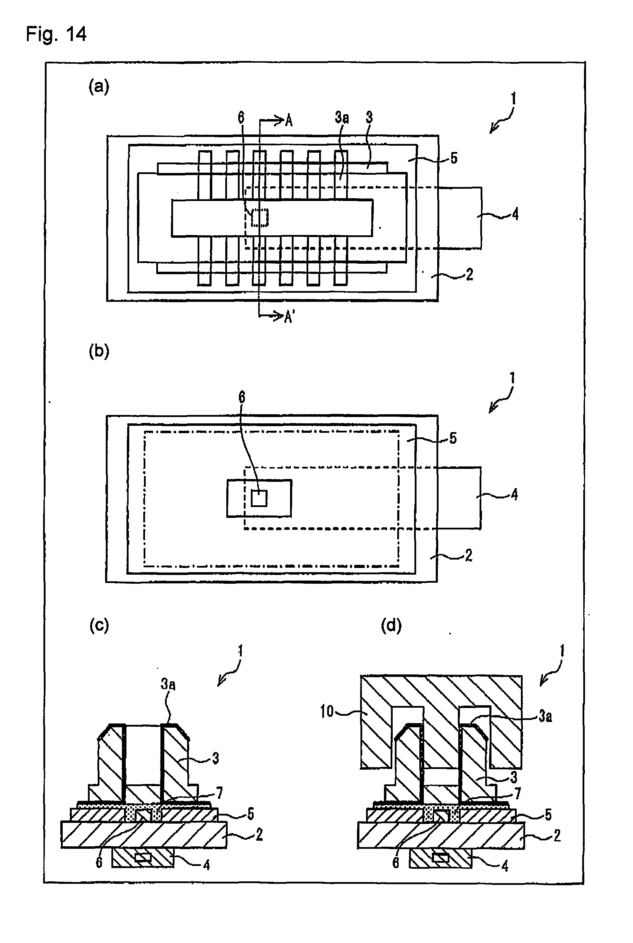

Fig. 14(a) is a plan view showing a configuration of the light transmission module according to the embodiment of the present invention, Fig. 14(b) is a plan view showing the configuration of the light transmission module shown in Fig. 14(a) when the connector is removed, and Fig. 14(c) is a cross-sectional view taken along line A-A' of the light transmission module 1 shown in Fig. 14(a). Fig. 14(d) is a cross-sectional view taken along line A-A' of the light transmission module 1 when the connector 3 of the light transmission module 1 shown in Fig. 14(a) is fitted to a receptor 10.

The light transmission module 1 according to the present embodiment has a configuration in which the light guide 4 is arranged on one surface of the substrate 2, and various types of members such as the optical element 6 are arranged on the other surface of the substrate 2. In the following, the surface of the substrate 2 arranged with the light guide 4 is referred to as the back surface of the substrate 2, and the opposite surface arranged with the connector 3 is referred to as the front surface.

As shown in Fig. 14(c), the light transmission module 1 has a configuration in which the optical element 6 and the reinforcement unit 5 are arranged on the front surface of the substrate 2, and the connector 3 is mounted on the reinforcement unit 5 such that the reinforcement unit 5 supports the connector 3. As shown in Fig. 14(a), the connector 3 includes a plurality of leg portions (terminals) 3a, and the connector 3 is stably supported on the reinforcement unit 5. In the present embodiment, the material of the leg portion 3a is metal.

The optical element 6 operates as a light receiving portion for receiving the light emitted from the end of the light guide 4, or a light transmitting portion for transmitting the light to the end of the light guide 4.

The reinforcement unit 5 functions as a supporting member for installing the connector 3 on the optical element 6. In the present embodiment, the reinforcement unit 5 is arranged to surround the four sides of the optical element 6, as shown in Fig. 14(b). The height of the reinforcement unit 5 from the front surface of the substrate 2 may be the same as the height of the optical element 6 from the front surface, or may be the height higher than or equal thereto. The connector 3 thus can be arranged so as to cover the surface (upper surface) of the optical element 6 on the side opposite to the adhering surface of the substrate 2. In other words, the connector 3 functions as the plate portion 5b of the reinforcement unit 5 in the above-described embodiments.

According to the above configuration, the light guide 4 can be arranged on the back surface of the substrate 2, and the optical element 6 and the connector 3 can be arranged in a stacked manner on the front surface of the substrate 2. Therefore, smaller space and miniaturization of the light transmission module can be realized while maintaining the rigidity of the substrate 2 and without being subjected to limitation in the arrangement of the light guide 4.

The reinforcement unit 5 may be made of the same material as the substrate 2, or may be made of resin material such as polyimide, LCP, epoxy, glass epoxy, and PEEK, rubber, or the like.

The reinforcement unit 5 may be integrally molded with the substrate 2, or the reinforcement unit 5 may be formed with a single body and then arranged on the substrate 2, but the light transmission module 1 can be manufactured at low cost and while maintaining the position accuracy of the reinforcement unit 5 itself high if the reinforcement unit 5 is integrally molded with the substrate 2. Since a gap does not form between the substrate 2 and the reinforcement unit 5 if the reinforcement unit 5 is integrally molded with the substrate 2, manufacturing having excellent reliability in moisture resistance and the like can be carried out.

Furthermore, as shown in Fig. 14(c), the underfill agent 7b for fixing the connector 3 to the reinforcement unit 5 is filled to between the reinforcement unit 5 and the connector 3. In the present embodiment, the underfill agent 7b is also filled to a space formed when the reinforcement unit 5 surrounds the optical element 6 at between the substrate 2 and the connector 3 since the underfill agent is injected from between the connector terminals (between the leg portion 3a and the leg portion 3a).

The injected underfill agent 7b does not leak out to the outside of the substrate 2 by surface tension. The underfill agent 7b of an amount sufficient to substantially satisfy the contacting surface of the connector 3 and the reinforcement unit 5, and the space, as shown with a chain dashed frame in Fig. 14(b), is to be injected.

According to the above configuration, the underfill agent 7b functions as a sealing agent for fixing or protecting the optical element 6 since the underfill agent 7b is filled to seal the optical element 6 in the space. Furthermore, the moisture resistance enhances since a gap does not form between the substrate 2 and the reinforcement unit 5.

As described above, the reinforcement unit 5 is arranged on the substrate 2 to surround the optical element 6, the connector 3 is mounted thereon, and the space formed thereby is filled with the underfill agent 7b, so that the reinforcement degree of the substrate 2 increases and the rigidity of the substrate 2 can be maintained.

Thus, the reinforcement unit 5 supports the substrate 2 from below, whereby the substrate 2 does not deform by the pressure applied at the time of mounting the light guide 4 even if the substrate 2 is thin and does not have rigidity, and the positional relationship between the optical element 6, which is already mounted, and the light guide 4, which is positioned before mounting, does not shift.

Therefore, when manufacturing the light transmission module 1, whether to arrange the light guide 4 on the back surface of the substrate 2 or to embed in the substrate 2 can be freely selected, and hence the degree of freedom in design enhances.

Therefore, the light transmission module can be miniaturized without complicating the manufacturing step or increasing the manufacturing cost by enhancing the degree of freedom in design in the light transmission module while maintaining the rigidity of the substrate.

The connector 3 is a male type having a plurality of projections when seen from a direction taken along line A-A'. The connector 3 mounted on the optical element 6 and the reinforcement unit 5 fits with the receptor 10, which is a female type connecting component, by the projection as shown in Fig. 14(d). Alternatively, the connector 3 may be a female type, and may fit with the receptor 10, which is a male type connecting component.

In the above-described description, a case in which the reinforcement unit 5 has a square shape so as to surround the four sides of the optical element 6 has been described by way of example, but the shape of the reinforcement unit 5 is not particularly limited. The reinforcement unit 5 may have a shape described above, as shown in Fig. 8(a), Fig. 8(b) or Fig. 9(a), Fig. 9(b).

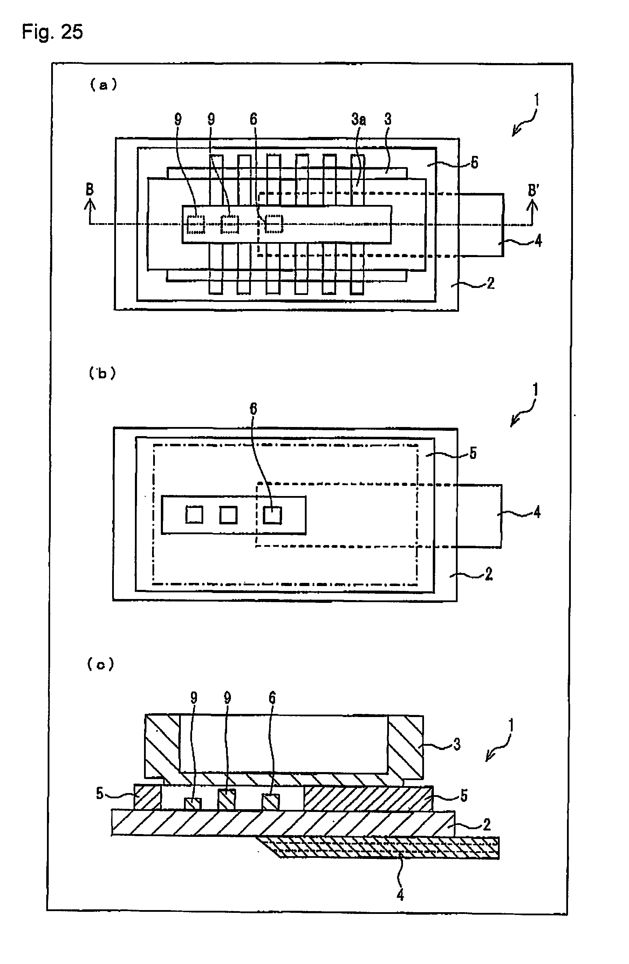

Furthermore, as shown in Figs. 25(a) to 25(c), in addition to the optical element 6, other necessary circuit elements 9 may be accommodated within the frame shape of the reinforcement unit 5, that is, the space formed by the reinforcement unit 5, the substrate 2, and the connector 3 in the light transmission module 1.

Fig. 25(a) is a plan view showing a configuration of the light transmission module according to the embodiment of the present invention, Fig. 25(b) is a plan view showing a configuration of the light transmission module shown in Fig. 25(a) when the connector is removed, and Fig. 25(c) is a cross-sectional view taken along line B-B' of the light transmission module 1 shown in Fig. 25(a).

As shown in Fig. 25(c), if the height of the reinforcement unit 5 from the front surface of the substrate 2 is higher than or equal to the height of the optical element 6 and each circuit element 9, the connector 3 can be mounted on the reinforcement unit 5.

According to the above configuration, the necessary optical element 6 and the circuit element 9 can be accommodated in the space formed by the reinforcement unit 5, the substrate 2, and the connector 3, and the space can be effectively used. Therefore, smaller element mounting space can be realized while maintaining the rigidity of the substrate 2 by the reinforcement unit 5, and the light transmission module can be miniaturized. The circuit element 9 may be an element for driving the optical element 6 such as a chip resistor, a chip capacitor, and an IC. Thus, the space of the arrangement region of the substrate 2 can be saved by accommodating the circuit element 9 originally necessary for the light transmission module 1 in the space, whereby the light transmission module 1 can be miniaturized. If the circuit element 9 includes an element having higher height than the light guide 4, the relevant element is mounted on the same surface as the optical element 6 to further thin the entire light transmission module 1.

### (Variant 2-1)

In the above description, an example of using the connector 3 for one part (i.e., plate portion 5b) of the reinforcement unit 5 has been described, but an example of using the connector 3 for the entire reinforcement unit 5 will be described below.

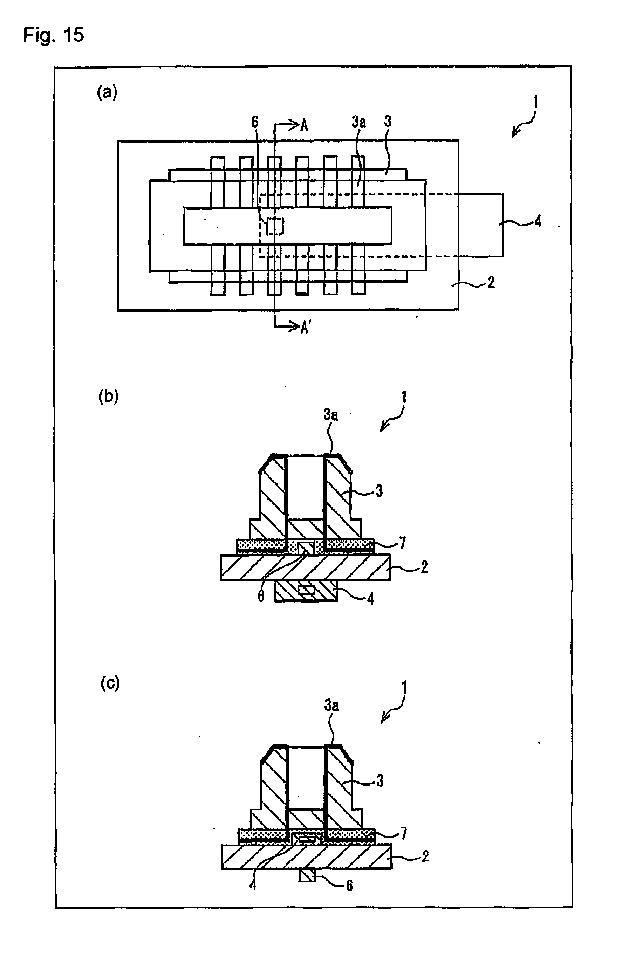

Fig. 15(a) is a plan view showing a configuration of the light transmission module 1 according to another embodiment of the present invention, and Fig. 15(b) is a cross-sectional view taken along line A-A' of the light transmission module shown in Fig. 15(a). Fig. 15(c) is a cross-sectional view taken along line A-A' of another light transmission module shown in Fig. 15(a).

As shown in Figs. 15(a) and 15(b), the connector 3 serving as the reinforcement unit 5 includes the leg portion 3a serving as the leg portion 5a. The connector 3 shown in Fig. 15(b) differs from that in Fig. 14(c) in that the leg portion 3a is extended by a constant length from the bottom surface facing the substrate 2 of the connector 3. The leg portion 3a extended by a constant length adheres with the substrate 2 by way of the underfill agent 7b, and supports the connector 3.

The length extended from the bottom surface of the connector 3 in the leg portion 3a is greater than or equal to the height of the optical element 6 from the front surface of the substrate 2. Therefore, the optical element 6 can be arranged in a space formed by the substrate 2, the leg portion 3a, and the bottom surface of the connector 3.

According to the above configuration, the optical element 6 and the connector 3 can be stacked and installed on the front surface of the substrate 2, and thus the miniaturization of the light transmission module 1 can be realized. For the back surface of the substrate 2, whether to arrange the light guide 4 or whether to embed the same in the substrate 2 can be appropriately selected, and then mounted thereon.

Furthermore, in the present variant, the connector 3 also serves as the plate portion 5b of the reinforcement unit 5 (lid covering the mounted element), and thus the member of the reinforcement unit 5 does not need to be separately arranged, and hence the light transmission module 1 can be thinned.

In the present embodiment, the leg portion 3a is made of metal, and is arranged in plurals at a constant interval along the two sides in the longitudinal direction of the bottom surface of the connector 3.

The underfill agent 7b is injected from between the leg portions 3a to a space formed by the connector 3 and the substrate 2, thereby adhering the connector 3 and the substrate 2 to each other. The arrangement interval of the leg portion 3a is very small, and thus the underfill agent 7b does not leak out from the substrate by surface tension. The rigidity of the substrate 2 can be further enhanced by curing the underfill agent 7b.

Thus, in the mounting step of the light guide 4, the substrate can be reinforced even if the substrate itself is thin and does not have rigidity, and the substrate is prevented from being bent by the pressure applied when mounting the light guide since the leg portion 3a of the connector 3 supports the substrate 2 from below. Therefore, the positional relationship between the optical element, which is already mounted, and the light guide, which is positioned before mounting, does not shift. Furthermore, the stripping of the resin agent 7 can be avoided since the bending of the substrate 2 can be prevented.

If the width of the light guide 4 (length in the direction along the line A-A' in Fig. 15(a)) is thin, the light guide 4 may be accommodated instead of the optical element 6 in the cavity formed by the substrate 2, the connector 3, and the leg portion 3a (or by the groove formed in the substrate direction of the bottom surface of the connector 3 and the substrate 2). In other words, as shown in Fig. 15(c), the positions of the optical element 6 and the light guide 4 may be reversed. In such a case, the bottom surface of the connector 3 can be sealed while leaving the cavity by tracing a small amount of sealing agent 7a only near the end of the connector 3. Therefore, the attachment of dust to the mirror end face (not shown) of the light guide 4 can be prevented.

Since the strength of the substrate 2 increases by the circuit element 9 by mounting the optical element and other circuit elements 9 serving as the reinforcement component on the front surface of the substrate 2, the substrate 2 can be prevented from bending in the step of mounting the light guide 4 and the connector 3 on the back surface. Consequently, the circuit element 9 serving as the reinforcement unit can be mounted on the front surface of the substrate 2, the connector 3 serving as the reinforcement component can be mounted on the back surface of the substrate 2, and the substrate 2 can be reinforced at both surfaces, so that the strength of the substrate 2 can be further enhanced.

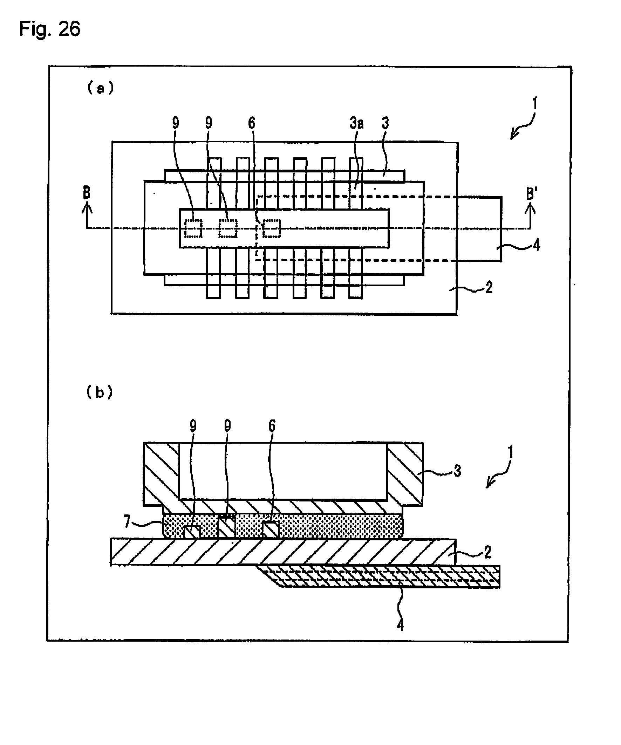

Furthermore, as shown in Figs. 26(a) and 26(b), other circuit elements 9 necessary in addition to the optical element 6 may be accommodated in the space formed by the connector 3, the leg portion 3a, and the substrate 2 in the light transmission module 1.

Fig. 26(a) is a plan view showing a configuration of the light transmission module according to the embodiment of the present invention, and Fig. 26(b) is a cross-sectional view taken along line B-B' of the light transmission module 1 shown in Fig. 26(a).

As shown in Fig. 26(b), if the height of the leg portion 3a supporting the connector 3 from the front surface of the substrate 2 is greater than or equal to the height of the optical element 6 and each circuit element 9, the connector 3 can be mounted on the optical element 6 and each circuit element 9.

According to the above configuration, the necessary optical element 6 and the circuit element 9 can be accommodated in the space formed by the substrate 2, and the connector 3, and the leg portion 3a, and the space can be effectively used. Therefore, smaller element mounting space can be realized while maintaining the rigidity of the substrate 2 by the connector 3, and the light transmission module can be miniaturized. The circuit element 9 may be a chip resistor, a chip capacitor, and an IC. Thus, the space of the arrangement region of the substrate 2 can be saved by accommodating the circuit element 9 originally necessary for the light transmission module 1 in the space, whereby the light transmission module 1 can be miniaturized.

### (Variant 2-2)

A configuration of the light transmission module 1 in which the connector 3 serving as the plate portion 5b of the reinforcement unit 5 includes a hole for passing the optical element 6 at the bottom surface will now be described. The bottom surface of the connector 3 refers to the surface facing to or adhering to the front surface of the substrate 2.

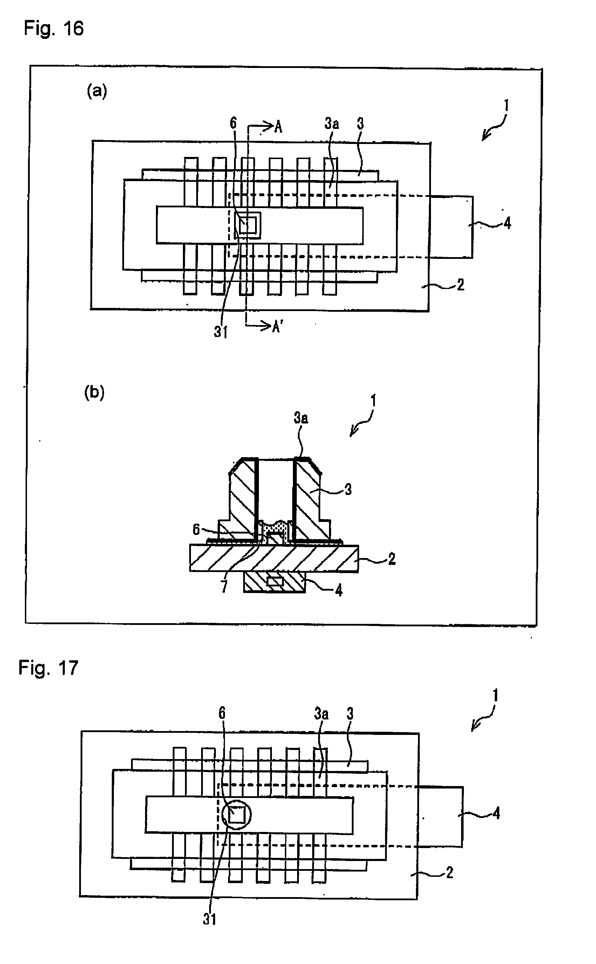

Fig. 16(a) is a plan view showing a configuration of the light transmission module 1 according to another embodiment of the present invention, and Fig. 16(b) is a cross-sectional view taken along line A-A' of the light transmission module 1 shown in Fig. 16(a).

The connector 3 shown in Figs. 16(a) and 16(b) differs from that of Figs. 14(a) and 14(c) in that the connector 3 includes a hole 31 at the bottom surface.

In the present embodiment, the shape of the hole 31 is a square, and the size thereof is a size sufficient for the optical element 6 to pass through.

According to the above configuration, the connector 3 can be arranged overlapping the optical element 6 even if the reinforcement unit 5 for increasing the bulk is not separately arranged or even if the leg portion 3a of the connector 3 does not have sufficient height.

As a result, the reinforcement unit 5 for increasing the bulk or the leg portion 3a having height is not necessary, whereby the element mounting area can be saved (reduced), and the light transmission module 1 can be thinned.

The underfill agent 7b for adhering the connector 3 to the substrate 2 can be injected from the hole 31.

The shape of the hole 31 may be a square or a rectangle such that the longitudinal direction is the same as the connector 3. The sealing agent 7a can be traced in one direction in the longitudinal direction by forming a horizontally long square hole 31, and a more even sealing can be achieved.

In the configuration of the connector 3 described up to now, the resin agent 7 needs to be injected from between the leg portions 3a of all sides to even the resin agent 7. Different from the method of injecting the resin agent 7 from plural areas, the resin agent 7 can be easily and evenly filled by forming the hole 31 at the bottom surface of the connector 3 and simply injecting the resin agent 7 from the hole 31 at one location. The tact time required for the injection step of the resin agent 7 thus can be reduced.

The shape of the hole 31 is not limited to a square (square, rectangle, etc.) and may be a polygon. Alternatively, the shape may be a circle as shown in Fig. 17, or an ellipse.

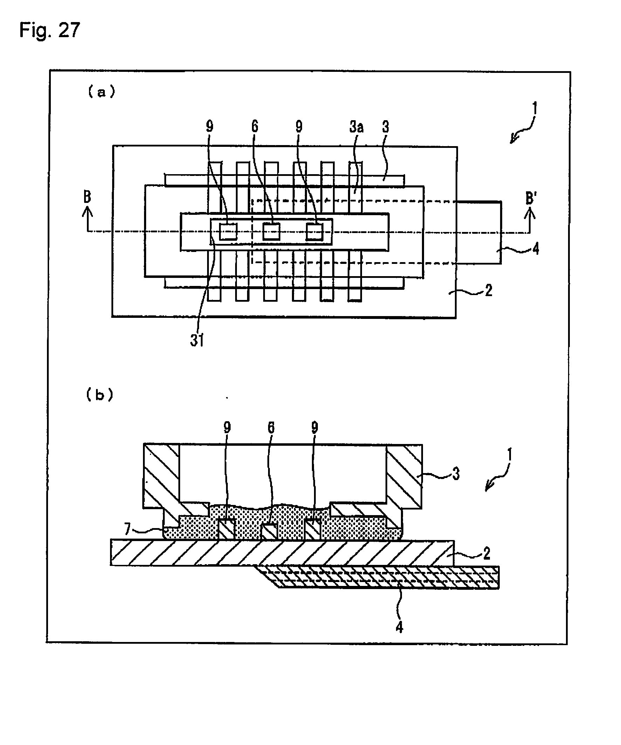

Furthermore, as shown in Figs. 27(a) and 27(b), if the connector 3 includes the hole 31 of a sufficient size at the bottom surface in the light transmission module 1, other circuit element 9 may be arranged on the substrate 2 in addition to the optical element 6.

Fig. 27(a) is a plan view showing a configuration of the light transmission module according to the embodiment of the present invention, and Fig. 27(b) is a cross-sectional view taken along line B-B' of the light transmission module 1 shown in Fig. 27(a).

According to the above configuration, the connector 3 can be arranged overlapping not only the optical element 6, but also the circuit element 9. Therefore, smaller element mounting space can be realized while maintaining the rigidity of the substrate 2 by the connector 3, and the light transmission module can be miniaturized. The circuit element 9 may be a chip resistor, a chip capacitor, and an IC. Thus, the space of the arrangement region of the substrate 2 can be saved by accommodating the circuit element 9 originally necessary for the light transmission module 1 in the space, whereby the light transmission module 1 can be miniaturized.

### (Variant 2-3)

In the above described variant, the hole 31 is formed at the bottom surface of the connector 3, but is not limited thereto. The optical element 6 and the connector 3 may be stacked and mounted on the substrate 2 by forming a recess capable of accommodating the optical element 6 in the longitudinal direction of the bottom surface of the connector 3.

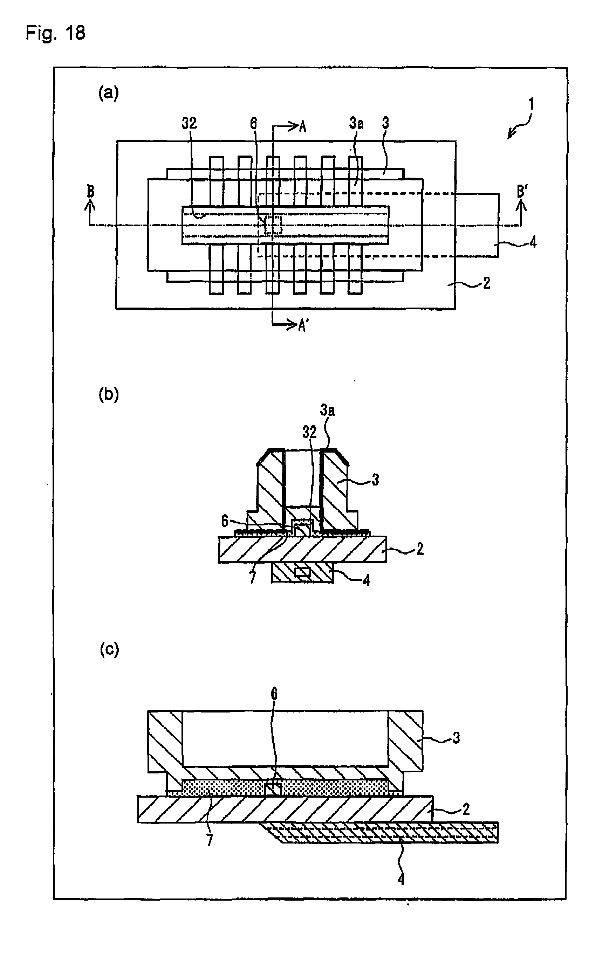

Fig. 18(a) is a plan view showing a configuration of the light transmission module 1 according to another embodiment of the present invention, Fig. 18(b) is a cross-sectional view taken along line A-A' of the light transmission module 1 shown in Fig. 18(a), and Fig. 18(c) is a cross-sectional view taken along line B-B' of the light transmission module shown in Fig. 18(a).

As shown in Figs. 18(a) to 18(c), the connector 3 according to the present variant includes a recess 32 having a width and a depth capable of accommodating the optical element 6 at the bottom surface in place of the hole 31. As shown in Figs. 18(a) and 18(c), the recess 32 is formed to substantially the same length as the opening at the surface opposite to the bottom surface in the longitudinal direction of the connector 3. That is, since the recess 32 does not pass through the bottom surface of the connector 3 like a tunnel, the resin agent 7 is injected from between the leg portions 3a of the connector 3 when filling the resin agent 7.

The depth of the recess 32 is greater than or equal to the height of the optical element 6 from the substrate 2, and the width of the recess 32 is greater than the width of the optical element 6.

According to the above configuration, the optical element 6 can be accommodated in the recess 32 by arranging the connector 3 on the substrate 2 so that the recess 32 is at the position of the optical element 6. Therefore, the connector 3 can be arranged overlapping the optical element 6 without separately arranging the reinforcement unit 5 for increasing the bulk or even if the leg portion 3a of the connector 3 does not have sufficient height.

As a result, the reinforcement unit 5 for increasing the bulk or the leg portion 3a having height is not necessary, whereby the element mounting area can be saved (reduced), and the light transmission module 1 can be thinned.

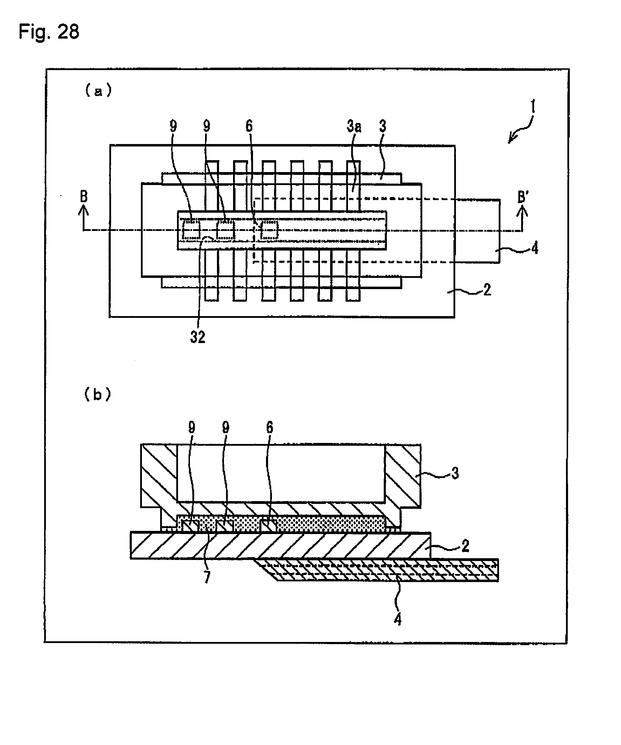

Furthermore, according to the above configuration, other circuit elements 9 can be arranged in a space formed by the recess 32 of the connector 3 and the substrate 2, as shown in Figs. 28(a) and 28(b), and thus the element mounting space in the substrate 2 can be saved.

Fig. 28(a) is a plan view showing a configuration of the light transmission module according to the embodiment of the present invention, and Fig. 28(b) is a cross-sectional view taken along line B-B' of the light transmission module 1 shown in Fig. 28(a).

Thus, the arrangement region of the substrate 2 can be reduced and the light transmission module 1 can be miniaturized by accommodating the circuit element 9 originally necessary for the light transmission module 1 in the space.

Since the resin agent 7 is filled in the space, the thickness of the adhering layer increases and the adhering strength increases.

The light guide 4 may be arranged on the back surface of the substrate 2, or may be embedded in the substrate 2.

Therefore, the rigidity of the substrate 2 can be maintained by the connector 3, the degree of freedom in design in the light transmission module can be enhanced, and the light transmission module can be miniaturized without complicating the manufacturing steps and increasing the manufacturing cost.

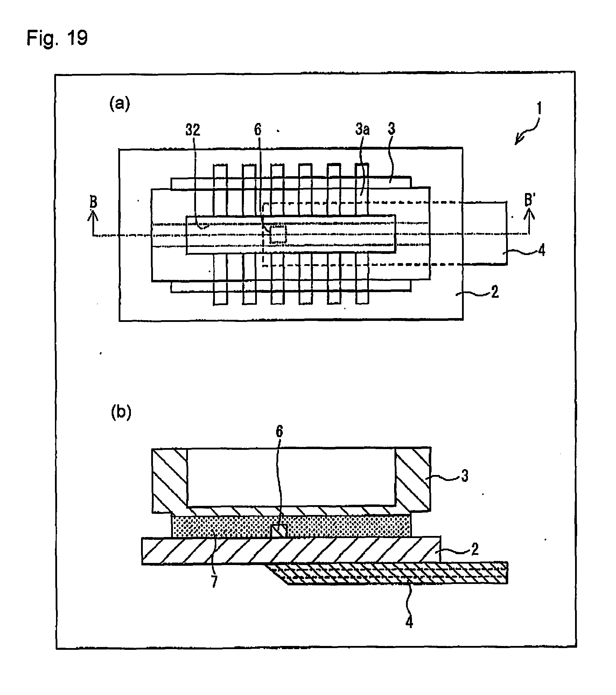

As shown in Figs. 19(a) and 19(b), the recess 32 may have a shape of passing through the bottom surface of the connector 3 like a tunnel.

According to the above configuration, the underfill agent 7b can be easily and evenly injected from both ends of the recess 32.

When injecting from between the leg portions 3a of the connector 3, the fillet shape of the underfill agent 7b forms at the leg portion 3a, and may interfere when fitting the lid. According to the above configuration, however, the size of the fillet shape can be reduced since the underfill agent 7b can be injected from both ends of the recess 32, and interference at the time of fitting can be avoided.

The configuration in which the recess 32 is formed in the longitudinal direction of the connector 3 has been described, but is not limited thereto, and one or a plurality of recesses may be arranged in the short-side direction of the connector 3. More specifically, the recess in the short-side direction heading straightly towards the recess 32 in the longitudinal direction of the connector 3 shown in Fig. 18(a) or Fig. 19(a) may be arranged in plurals at a constant interval.

According to the above structure, the adhering strength further increases as the region where the thickness of the adhering layer is increased can be increased.

The fluidity of the underfill agent 7b to be filled to the bottom surface of the connector 3 can be ensured, and the underfill agent 7b can be more evenly filled.

A second recess 33 deeper than the recess 32 and having smaller width than the recess 32 may be formed in the first recess 32 for accommodating the optical element 6 at the bottom surface of the connector 3.

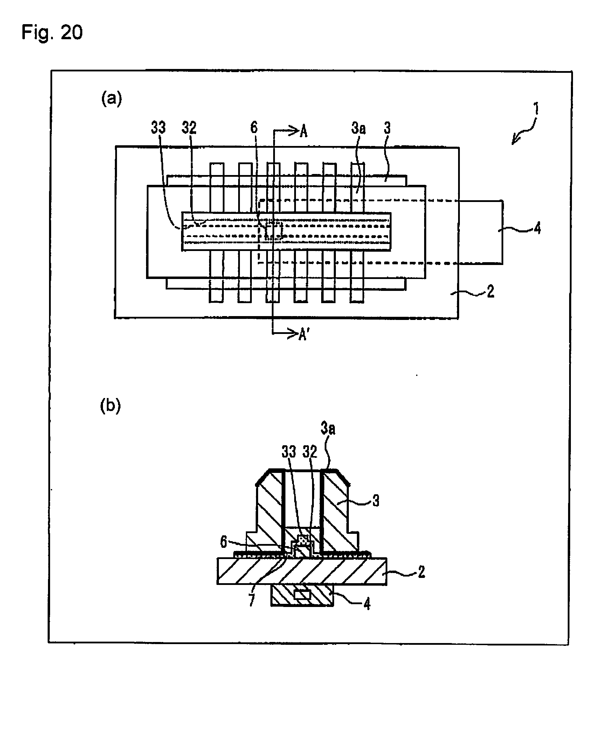

Fig. 20(a) is a plan view showing a configuration of the light transmission module 1 according to another embodiment of the present invention, and Fig. 20(b) is a cross-sectional view taken along line A-A' of the light transmission module 1 shown in Fig. 20(a).

The connector 3 shown in Figs. 20(a) and 20(b) differs from that of Figs. 18(a) and 18(b) in that the connector 3 includes the second recess 33 that is deeper and that has smaller width in the recess 32.

According to the above configuration, the fluidity of the underfill agent 7b to be filled inside can be enhanced by the space formed by the second recess 33, whereby generation of air bubbles can be suppressed.

Alternatively, an opening 34 having a smaller width than the recess 32 may be formed inside the recess 32 in place of the second recess 33 at the bottom surface of the connector 3.

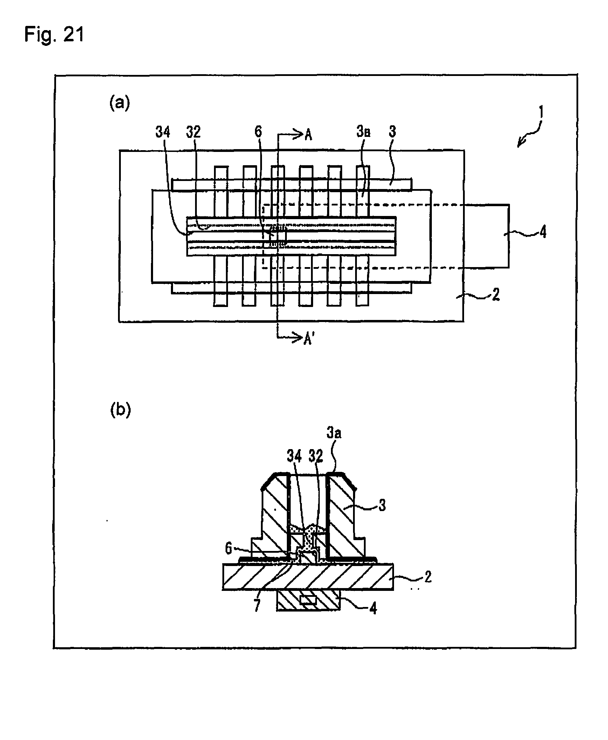

Fig. 21 (a) is a plan view showing a configuration of the light transmission module 1 according to another embodiment of the present invention, and Fig. 21 (b) is a cross-sectional view taken along line A-A' of the light transmission module 1 shown in Fig. 21 (a).

The connector 3 shown in Figs. 21 (a) and 21 (b) differs from that shown in Figs. 20(a) and 20(b) in that the connector 3 includes an opening 34 in place of the second recess 33 at the bottom surface.

According to the above configuration, since the connector 3 includes the opening 34, the fluidity of the underfill agent 7b can be further enhanced, the generation of air bubbles can be suppressed, and the underfill agent 7b can be evenly applied. Therefore, the underfill agent 7b is prevented from running out to the interior of the connector 3 and the interference to the alignment of the circuit element 9 of the interior of the connector 3 is eliminated.

The sealing agent 7a can be injected from the opening 34.

A configuration including a core made of material having transparency and a clad made of material having an index of refraction different from the index of refraction of the core is considered for the configuration of the light transmission path. In each embodiment described above, the clad is described as being made of solid material, but is not limited thereto. The clad may be made of liquid material or gas material.

### (Application example)

The light guide 4 of the present embodiment can be applied to the following application examples.

First, as a first application example, use can be made at the hinge portion in a foldable electronic device such as a foldable mobile phone, a foldable PHS (Personal Handy-phone System), a foldable PDA (Personal Digital Assistant), and a foldable notebook computer.

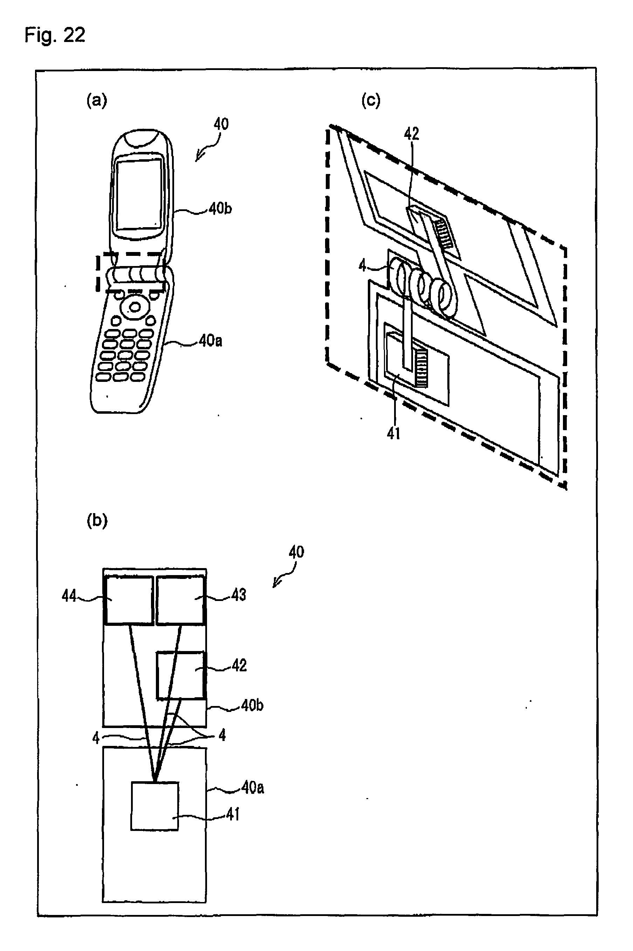

Figs. 22(a) to 22(c) show an example in which the light guide 4 is applied to a foldable mobile phone 40. Fig. 22(a) is a perspective view showing an outer appearance of the foldable mobile phone 40 incorporating the light guide 4.

Fig. 22(b) is a block diagram of a portion where the light guide 4 is applied in the foldable mobile phone 40 shown in Fig. 22(a). As shown in the figure, a control unit 41 arranged on a body 40a side in the foldable mobile phone 40, and an external memory 42, a camera (digital camera) 43, and a display unit (liquid crystal display) 44 arranged on a lid (drive portion) 40b side rotatably arranged at one end of the body with the hinge portion as a shaft are connected by the light guide 4.

Fig. 22(c) is an exploded plan view of the hinge portion (portion surrounded with a broken line) in Fig. 22(a). As shown in the figure, the light guide 4 is wrapped around a supporting rod at the hinge portion and bent to thereby connect the control unit arranged on the body side, and the external memory 42, the camera 43, and the display unit 44 arranged on the lid side.

High speed and large capacity communication can be realized in a limited space by applying the light guide 4 to the foldable electronic device. Therefore, it is particularly suitable in devices where high speed and large capacity data communication is necessary and miniaturization is demanded such as the foldable liquid crystal display device.

As a second application example, the light guide 4 is applied to a device having a drive portion such as a printer head in a printing device (electronic device) and a reading unit in a hard disc recording and reproducing device.

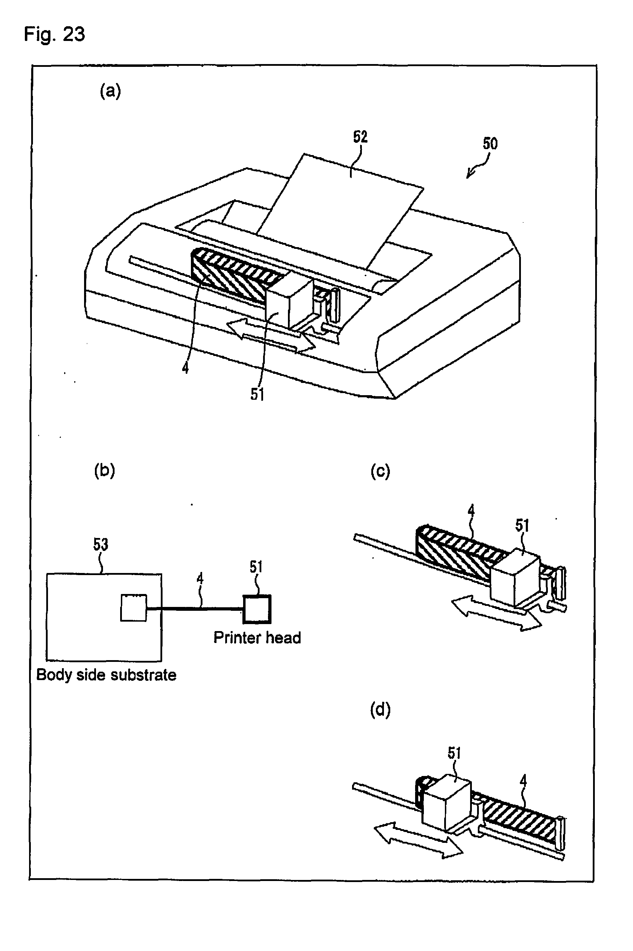

Figs. 23(a) to 23(c) show an example in which the light guide 4 is applied to a printing device 50. Fig. 23(a) is a perspective view showing an outer appearance of the printing device 50. As shown in the figure, the printing device 50 includes a printer head 51 for performing printing on a paper 52 while moving in a width direction of a paper 52, where one end of the light guide 4 is connected to the printer head 51.

Fig. 23(b) is a block diagram of a portion where the light guide 4 is applied in the printing device 50. As shown in the figure, one end of the light guide 4 is connected to the printer head 51, and the other end is connected to a body side substrate in the printing device 50. The body side substrate includes a control means etc. for controlling the operation of each unit of the printing device 50, and the like.

Figs. 23(c) and 23(d) are perspective views showing a curved state of the light guide 4 when the printer head 51 is moved (driven) in the printing device 50. As shown in the figure, when the light guide 4 is applied to the drive portion such as the printer head 51, the curved state of the light guide 4 changes by the drive of the printer head 51 and each position of the light guide 4 repeatedly curves.

Therefore, the light guide 4 according to the present embodiment is suited for such drive portion. High speed and large capacity communication using the drive portion can be realized by applying the light guide 4 to such drive portion.

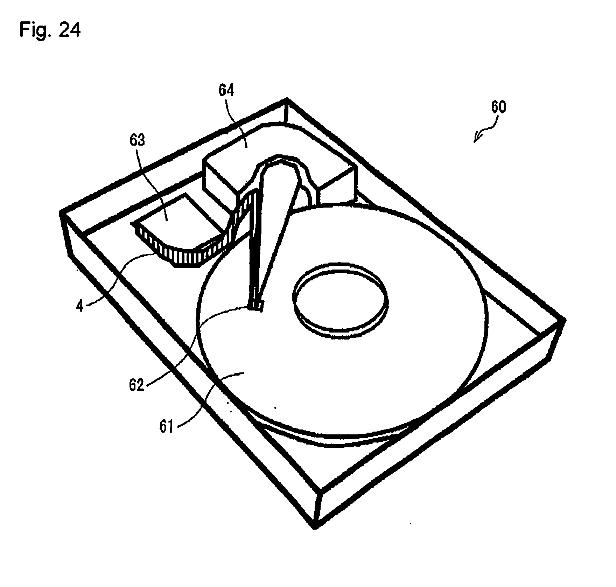

Fig. 24 shows an example in which the light guide 4 is applied to a hard disc recording and reproducing device 60.

As shown in the figure, the hard disc recording and reproducing device 60 includes a disc (hard disc) 61, a head (read/write head) 62, a substrate introducing portion 63, a drive portion (drive motor) 64, and the light guide 4.

The drive portion 64 drives the head 62 along a radial direction of the disc 61. The head 62 reads the information recorded on the disc 61 and writes information on the disc 61. The head 62 is connected to the substrate introducing portion 63 by way of the light guide 4, and propagates the information read from the disc 61 to the substrate introducing portion 63 as an optical signal and receives the optical signal of the information to write to the disc 61 propagated from the substrate introducing portion 63.

Therefore, high speed and large capacity communication can be realized by applying the light guide 4 to the drive portion such as the head 62 in the hard disc recording and reproducing device 60.

### [Supplementary matters]

In the light transmission module according to the present invention, the height of the reinforcement component from the substrate surface is preferably greater than or equal to the height of the optical element from the substrate surface.

Thus, the reinforcement component has a sufficient thickness (height from the front surface of the substrate 2) in the normal direction of the substrate surface. Thus, the substrate can be reinforced, and the rigidity can be sufficiently maintained. For instance, the substrate can be reinforced even if the reinforcement component is made of the same material as the substrate.

Other members can be mounted on the reinforcement component, and the optical element and the other members can be arranged in a stacked manner. The member mounting region of the substrate thus can be saved.

At least one part of the region where the reinforcement component is arranged in the substrate preferably overlaps the region where the end of the light transmission path is arranged at the surface opposite to the surface mounted with the reinforcement component.

Thus, the region where the reinforcement component is not arranged on the optical element mounting surface of the substrate has the light guide arranged on the opposite surface (or light guide is embedded in the substrate), whereby the substrate is reinforced by either at least the reinforcement component or the light guide, and the strength of reinforcement increases with respect to the bending of the substrate in the direction the optical element and each member of the structural portions of the reinforcement component arranged in an opposing manner through the optical element are arranged.

The reinforcement component may be arranged to surround the periphery of the optical element in the direction parallel to the substrate surface.

According to the above configuration, the region where the optical element of the substrate is arranged and the region at the periphery thereof are reinforced in all directions, and bend can be prevented.

The reinforcement component may be arranged on the substrate through the leg portion projecting out on the substrate surface.

According to the above configuration, the projecting leg portion is arranged on the substrate in a form of supporting the reinforcement component.

Thus, the substrate is merely adhered with the leg portion, and the adhering area of the reinforcement component and the substrate can be reduced.

When the adhering area with respect to the substrate reduces, the area for applying the adhesive (underfill agent) for adhering the reinforcement component to the substrate becomes smaller, and the usage amount of the adhesive can be reduced. Thus, the amount the extra adhesive runs out towards the central part of the substrate can be significantly reduced when the reinforcement component is pushed against the substrate. The central part of the substrate is normally ensured as a region for mounting the optical element and other circuit elements (or already mounted), and thus, the influence on the alignment of the elements to arrange at the central part can be reduced by reducing the amount the adhesive runs out. Therefore, a stable light transmission module of high quality can be manufactured.

The connecting component may include a terminal serving as the leg portion, and may be arranged on the substrate by way of the terminal. The mounting to the substrate is facilitated since the connecting component and the terminal are integrated.

The optical element may be arranged between the substrate and the connecting component arranged on the substrate while being supported by the terminal.

According to the above configuration, the connecting component is mounted on the optical element mounted on the substrate. Thus, the substrate can be reinforced, and smaller space of the mounting region of substrate can be realized.

The reinforcement component includes an opening, and may be arranged on the substrate so that the optical element is arranged within the opening.

According to such configuration, the reinforcement component can be arranged overlapping the optical element without damaging the optical element. Furthermore, the reinforcement component does not need to be stacked while ensuring a certain height from the substrate so as not to touch the optical element.

The maximum height from the substrate surface thus can be reduced, and the light transmission module can be further thinned.

The reinforcement component includes a structural portion that covers the surface opposite to the adhering surface with the substrate in the optical element, which structural portion may include a recess on the substrate side, and the optical element may be accommodated in a space formed by the substrate and the recess.

According to such configuration, the reinforcement component can be arranged overlapping the optical element without damaging the optical element. Furthermore, the reinforcement component does not need to be stacked while ensuring a certain height from the substrate so as not to touch the optical element.

The maximum height from the substrate surface thus can be reduced, and the light transmission module can be further thinned.

The reinforcement component may be molded with material same as the substrate.

Thus, the reinforcement component can be integrally molded with the substrate, and a light transmission module can be manufactured at low cost and while maintaining the position accuracy of the reinforcement component itself high.

Alternatively, the reinforcement component may be a circuit element arranged near the optical element.

Therefore, an extra member does not need to be arranged or stacked by using each circuit element to be mounted on the light transmission module for the reinforcement component, whereby the light transmission module can be formed smaller while maintaining the rigidity of the substrate.

The resin agent is preferably filled to a space formed by the reinforcement component and the substrate, and the resin agent preferably seals the optical element.

According to the above configuration, the resin agent protects the optical element from moisture and dust, prevents degradation of the optical element, and further maintains the rigidity of the substrate by being filled and cured in a space between the reinforcement component and the substrate.

The present invention is not limited to the above-described embodiments, and various modifications may be made within the scope of the Claims. In other words, embodiments obtained by combining technical means appropriately modified within the scope of the Claims are also encompassed in the technical scope of the present invention.

### INDUSTRIAL APPLICABILITY

The light transmission module according to the present invention can also be applied to the optical communication path between various types of devices, and can also be applied to the flexible optical wiring serving as the in-device wiring mounted on the small and thin commercially-off-the-shelf device. Specifically, use can be suitably made to the light transmission module using a thin substrate that easily bends since the rigidity of the substrate is maintained by the reinforcement component.

## Claims

1. A light transmission module including an optical element for emitting or receiving an optical signal with respect to at least one end, which includes an incident/exit port of the optical signal, of a light transmission path including a core made of material having transparency, and a substrate for mounting the optical element, the end of the light transmission path being arranged to optically couple with the optical element; the light transmission module comprising:
a reinforcement component for reinforcing the substrate; wherein
the reinforcement component is arranged on a surface mounted with the optical element of the substrate: and
the reinforcement component includes at least two structural portions longer than a maximum length portion of the optical element when seen from a direction perpendicular to the substrate surface, the two structural portions being arranged facing each other with a region, where at least the optical element is arranged, in between when seen from the direction perpendicular to the substrate surface.

2. The light transmission module according to claim 1, wherein a height of the reinforcement component from the substrate surface is greater than or equal to a height of the optical element from the substrate surface.

3. The light transmission module according to claim 1, wherein at least one part of the region arranged with the reinforcement component in the substrate overlaps a region arranged with the end of the light transmission path on a surface opposite to a surface mounted with the reinforcement component.

4. The light transmission module according to claim 1, wherein the reinforcement component is arranged to surround the periphery of the optical element in a direction parallel to the substrate surface.

5. The light transmission module according to claim 1, wherein the reinforcement component is arranged on the substrate by way of a leg portion projecting out on the substrate surface.

6. A light transmission module including an optical element for emitting or receiving an optical signal with respect to at least one end, which includes an incident/exit port of the optical signal, of a light transmission path including a core made of material having transparency, and a substrate for mounting the optical element, the end of the light transmission path being arranged to optically couple with the optical element; the light transmission module comprising:
a reinforcement component for reinforcing the substrate, the reinforcement component including, on at least one part, a connecting component for electrically connecting a substrate of an external electronic device and the light transmission module; wherein
the connecting component is arranged on a surface mounted with the optical element of the substrate; and
the connecting component includes at least two structural portions longer than a maximum length portion of the optical element when seen from a direction perpendicular to the substrate surface, the two structural portions being arranged facing each other with a region, where at least the optical element is arranged, in between when seen from the direction perpendicular to the substrate surface.

7. The light transmission module according to claim 6, wherein the connecting component includes a terminal serving as a leg portion, and is arranged on the substrate by way of the terminal.

8. The light transmission module according to claim 7, wherein the optical element is arranged between the substrate and the connecting component arranged on the substrate by being supported by the terminal.

9. The light transmission module according to claim 1, wherein the reinforcement component includes an opening, and is arranged on the substrate so that the optical element is arranged in the opening.

10. The light transmission module according to claim 6, wherein the reinforcement component includes an opening, and is arranged on the substrate so that the optical element is arranged in the opening.

11. The light transmission module according to claim 1, wherein
the reinforcement component includes a structural portion that covers a surface opposite to an adhering surface with the substrate in the optical element, the structural portion including a recess on the substrate side, and the optical element being accommodated in a space formed by the substrate and the recess.

12. The light transmission module according to claim 6, wherein
the reinforcement component includes a structural portion that covers a surface opposite to an adhering surface with the substrate in the optical element, the structural portion including a recess on the substrate side, and the optical element being accommodated in a space formed by the substrate and the recess.

13. The light transmission module according to claim 1, wherein the reinforcement component is molded with a material same as the substrate.

14. The light transmission module according to claim 1, wherein the reinforcement component is a circuit element arranged near the optical element.

15. The light transmission module according to claim 1, wherein a resin agent is filled to a space formed by the reinforcement component and the substrate, and the resin agent seals the optical element.

16. The light transmission module according to claim 6, wherein a resin agent is filled to a space formed by the reinforcement component and the substrate, and the resin agent seals the optical element.

17. A light transmission module including an optical element for emitting or receiving an optical signal with respect to at least one end, which includes an incident/exit port of the optical signal, of a light transmission path including a core made of material having transparency, and a substrate for mounting the optical element, the end of the light transmission path being arranged to optically couple with the optical element; the light transmission module comprising:
a reinforcement component for reinforcing the substrate, the reinforcement component including, on at least one part, a connecting component for electrically connecting a substrate of an external electronic device and the light transmission module; wherein
the connecting component is arranged on a surface mounted with the optical element of the substrate; and
the connecting component includes a structural portion that covers a surface opposite to an adhering surface with the substrate in the light transmission path, the structural portion including a recess on the substrate side, and the light transmission path being accommodated in a space formed by the substrate and the recess.

18. An electronic device comprising the light transmission module according to claim 1.

19. An electronic device comprising the light transmission module according to claim 6.

20. An electronic device comprising the light transmission module according to claim 14.
